# EUROPEAN PATENT SPECIFICATION

(11) **EP 1 802 184 B1**
(45) Date of publication and mention of the grant of the patent: **03.11.2010**
(21) Application number: 05774860.0
(22) Date of filing: 25.08.2005
(51) Int. Cl.: H05K 3/10, G03F 7/40, B05D 5/12, C08J 7/04, H01B 13/00

(54) **METHOD FOR MANUFACTURING AN ELECTRO-CONDUCTIVE PATTERN MATERIAL**
VERFAHREN ZUR HERSTELLUNG EINES ELEKTRISCH LEITFÄHIGEN STRUKTURMATERIALS
PROCÉDÉ DE FABRICATION DE MATÉRIAU À MOTIF CONDUCTEUR D'ÉLECTRICITÉ

(30) Priority: 26.08.2004 JP 2004246460; 26.08.2004 JP 2004246461
(43) Date of publication of application: 27.06.2007
(73) Proprietor: FUJIFILM Corporation, Minato-ku Tokyo 106-8620 (JP)
(72) Inventor: KAWAMURA, Koichi, c/o FUJIFILM Corporation, Ashigarakami-gun, Kanagawa 258-8577 (JP); KANO, Takeyoshi, c/o FUJIFILM Corporation, Ashigarakami-gun, Kanagawa 258-8577 (JP)
(74) Representative: Siegert, Georg
(86) International application number: PCT/JP2005/015392
(87) International publication number: WO 2006/022312

(56) References cited:
- EP-A- 0 130 462
- EP-A- 1 447 145
- EP-A- 1 475 230
- JP-A- 2003 114 525
- JP-A- 2003 345 038
- JP-A- 2004 161 995
- US-A1- 2004 126 712

## Description

### Technical Field

The present invention relates to a method for manufacturing an electro-conductive pattern material and, more particularly, it relates to a method for manufacturing of an electro-conductive pattern material useful as a substrate for printed circuit board or the like.

### Background Art

Conventionally, various kinds of conductive pattern materials have been used for the formation of wiring boards. A typical pattern-forming method that has been commonly used is one in which a thin film of an electro-conductive material, formed by a conventional method such as vacuum deposition, is formed on an electrical insulator and then subjected to a resist treatment, portions of the previously prepared resist are removed by pattern exposure and, thereafter, subject to etching to form a desired pattern. In such a method requires at least four processes are required and it is a complicated process. Further, when wet etching is conducted for the etching treatment in this method, a disposal process for the waste liquid therefrom is necessary resulting in the necessity of more complicated treatment.
Further, there is also another known pattern-forming method for a conductive pattern, a method that uses photoresist materials. This is a method where a substrate coated with a photoresist polymer, or to which a photoresist on dry film is adhered, is subjected to UV exposure through a desired photomask to form a lattice-shaped pattern, and this method is useful for the formation of an electromagnetic wave shield which requires a high electrical conductivity.
However, with the progress of the development of micromachines and further miniaturization of Very Large Scale Intergration in recent years, the wiring structure thereof is also required to be as fine as nano level and, in conventional metal etching, there is a limitation to miniaturization, and breakage of fine wire portions during etching treatment is also a matter for concern.

As to a technique for dealing with such problems in miniaturization and breakage of the pattern, there is a proposal for a method where a pattern by a graft polymer showing hydrophilicity is formed on the surface of a support and an electro-conductive material layer is formed on the hydrophilic pattern to give an electro-conductive pattern material (refer, for example, to Patent Document 1). Such an electro-conductive material layer is constituted from electro-conductive particles which are fixed by being ionically adsorbed to the graft polymer bonded to the substrate surface and this electro-conductive pattern material has the characteristics that an electro-conductive pattern at high resolution and with no breakage of wire may be obtained. However, there is a fear of the release electro-conductive particles fixed by ionic bond as in this electro-conductive pattern material from the graft polymer, when the particles contact with an electrolyte solution such as a solution of salt.

With regard to the formation of an electro-conductive pattern on the substrate surface, it is also possible that, in order to improve the adhesiveness of the substrate to metal, the substrate surface is made uneven by an etching treatment and the adhesiveness is improved due to an anchor effect, but it is not advantageous to make the substrate uneven from the point of view of fine wiring and applicability to high frequencies. In order to improve these points, it is also possible that a graft polymer be bonded to the substrate surface and achieve high adhesiveness by having the graft polymer as an intermediate. As to such a technique, there is a proposal in, for example, N. Inagaki, S. Tasaka, M. Mastumoto, Macromolecules, 1996, volume 29, page 1642m for a method where a polyimide substrate is subjected to a plasma treatment to introduce a polymerization initiating group onto the surface of the polyimide substrate, and monomers are polymerized from the polymerization initiating group so that, by conducting surface treatment where a surface graft polymer is introduced onto the surface of the polyimide substrate, adhesiveness of the polyimide substrate to a copper layer is improved. In that technique, however, there is a problem that a large scale treatment is necessary, such as in plasma treatment.
There is another problem that, when a graft polymer is bonded to the substrate surface, although sufficiently adhesiveness is achieved between the substrate and the metal, the metal detaches from the graft polymer under some conditions such as high humidity. Electro-conductive pattern-forming processes comprising the formation of a polymerisation initiation layer directly on a substrate are also known (EP-A-1 475 230 relevant under Article 54 (3) EPC)). The polymerisation initiation layer comprises functional groups with cross-linking groups in the side chain and functional groups with polymerisation initiation ability. Once formed, a pattern forming step is conducted comprising the formation of a graft polymer having a polar group on the surface of the polymerisation initiation layer. The second step comprises supplying a compound with a polmerisable group and a cross linking group on the surface of the polymerisation initiation layer and supplying energy imagewise. Conductive material is then adsorbed on the graft polymer. A further method for producing a conductive pattern comprises the image-wise formation of region on a substrate surface having an ability to initiate polymerisation (US-A-2004/0126712). A graft polymer is then formed on the polymerisation initiation regions to provide a hydrophilic/hydrophobic pattern. Finally, a conductive material is adsorbed to either the hydrophobic or hydrophilic regions of the surface to provide a conductive pattern.

As mentioned above, it is currently the case that further improvement is demanded in the retention and durability of electro-conductive materials, such as metals, that are not only able to form a conductive pattern with high resolution and without wire breakage but also that have high electrical conductivity and adhesiveness.
Patent Document 1: Japanese Patent Application Laid-Open (JP-A) No. 2003-114, 525.

### Disclosure of Invention

### Problems to be Solved by the Invention

The subject of the present invention is to solve various problems in the above-mentioned prior art and to achieve the following objects.
Thus, an object of the present invention is to provide a method for manufacturing an electro-conductive pattern material equipped with an electro-conductive pattern having high resolving power, without wiring breakage and with excellent in its durability.
Another object of the present invention is to provide a method for manufacturing an electro-conductive pattern material equipped with an electro-conductive pattern having high resolving power and high electrical conductivity where the electro-conductive pattern material has a high adhesiveness to a substrate and has excellent retention and durability of the electro-conductive material.

### Means for Solving the Problems

As a result of intensive study, the present inventors have found that the above-mentioned problems can be solved by introduction of a cross-linking structure into an adsorption layer of an electro-conductive material-adhering substance or electro-conductive particles containing a graft polymer to which electro-conductive particles and electro-conductive material-adsorptive material are adhered so that the present invention has been achieved.

A first embodiment of the present invention is a method for manufacturing an electro-conductive layer which is characterized in comprising
bonding a graft polymer directly on a substrate in pattern form by contacting a polymerizable compound having a functional group which can interact with electro-conductive particles and a polymerizable compound having a cross-linking property at the substrate surface and supplying energy in a pattern form, wherein each of the polymerizable compounds is independently a monomer, macromonomer or a polymer having a polymerizable group;
forming an electro-conductive particle-adsorbing layer by adsorbing electro-conductive particles to the functional group which can interact with the electro-conductive particles of the graft polymer; and
forming a cross-linking structure in the electro-conductive particle-adsorbing layer by applying energy thereto.

As mentioned above, the present invention includes directly bonding a graft polymer onto a substrate in a pattern form, adsorbing electro-conductive particles to the interacting group of the graft polymer to form an electro-conductive particle-adsorbing layer and then making a cross-linking groups existing in the graft polymer react to form a cross-linking structure in the electro-conductive particle-adsorbing layer.
Although the mode of action of the first embodiment of the present invention is not clear, it is presumed to be as follows.
In the present invention, a cross-linking structure is formed in an electro-conductive particle-adsorbing layer whereby the electro-conductive particles adsorbed with the interacting group of the graft polymer are further included in the cross-linking structure and physically fixed. As a result, it is thought that, in the electro-conductive particle-adsorbing layer according to the present invention, there is a significant improvement not only in retention of electro-conductive particles caused by the presence of an interacting group of the graft polymer but also in durability of retention of the electro-conductive particles by fixation caused by the presence of the cross-linking structure in the electro-conductive particle-adsorbing layer.

A second embodiment of the present invention is a method for manufacturing an electro-conductive pattern material which is characterized in comprising
bonding a graft polymer directly on a substrate in pattern form by contacting a polymerizable compound having a functional group which can interact with an electroless plating catalyst or a precursor thereof and a polymerizable compound having a cross-linking property at the substrate surface and supplying energy in a pattern form, wherein each of the polymerizable compounds is independently a monomer, macromonomer or a polymer having a polymerizable group;
forming an electroless plating catalyst-containing layer by adding the electroless plating catalyst or a precursor thereof to the graft polymer;
applying energy to the electroless plating catalyst-containing layer to form a cross-linking structure in the electroless plating catalyst-containing layer; and
conducting an electroless plating.
In this embodiment, it is preferred to further conduct electroplating after the above-mentioned electroless plating step.

Although the action of the second embodiment in the present invention is not clear, it is hypothesized to be as follows.
In the present invention, a cross-linking structure is formed in an electroless plating catalyst-containing layer and, as a result, the electroless plating catalyst or a precursor thereof adsorbed or impregnated with the interacting group of the graft polymer is further included in the cross-linking structure and is physically fixed. The electro-conductive pattern material prepared by the present invention is prepared by subjecting the above-mentioned electroless plating catalyst-containing layer to an electroless plating and has a high resolving power and achieves high electric conductivity and adhesiveness. At the same time, since the metal deposited therefrom (electro-conductive material) is strongly retained in the cross-linking structure and, therefore, it is hypothesized not to be detached from the graft polymer and retention is not deteriorated.

### Advantages of the Invention

In accordance with the present invention, it is now possible to provide a method for the manufacture of an electro-conductive pattern material having electro-conductive pattern with high resolving power, without breakage of wiring and with an excellent durability and having an electro-conductive pattern with a high resolving power and high electric conductivity where the electro-conductive material has a highly adhesiveness to a substrate and retention and of the electro-conductive material and durability thereof are excellent.

### Best Mode for Carrying Out the Invention

Details of the present invention will now be explained. The first embodiment will be firstly mentioned. The method for manufacturing an electro-conductive pattern material of the first embodiment of the present invention includes the following three steps.
(1) bonding a graft polymer directly on a substrate in pattern form by contacting a polymerizable compound having a functional group which can interact with electro-conductive particles and a polymerizable compound having a cross-linking property at the substrate surface and supplying energy in a pattern form, wherein each of the polymerizable compounds is independently a monomer, macromonomer or a polymer having a polymerizable group;
(2) forming an electro-conductive particle-adsorbing layer by adsorbing electro-conductive particles to the functional group which can interact with the electro-conductive particles of the graft polymer; and
(3) forming a cross-linking structure in the electro-conductive particle-adsorbing layer by applying energy thereto.

The method for manufacturing an electro-conductive pattern material of the second embodiment of the present invention includes the following processes (1') to (4).Thus, the method for manufacture of an electro- conductive pattern material includes:
(1') bonding a graft polymer directly on a substrate in pattern form by contacting a polymerizable compound having a functional group which can interact with an electroless plating catalyst or a precursor thereof and a polymerizable compound having a cross-linking property at the substrate surface and supplying energy in a pattern form, wherein each of the polymerizable compounds is independently a monomer, macromonomer or a polymer having a polymerizable group;
(2') forming an electroless plating catalyst-containing layer by adding the electroless plating catalyst or a precursor thereof to the graft polymer;
(3') applying energy to the electroless plating catalyst-containing layer to form a cross-linking structure in the electroless plating catalyst-containing layer; and
(4') conducting an electroless plating.

As hereunder, each of the steps in the present invention will be successively illustrated.

### < Forming a graft polymer pattern >

In the present invention, a graft polymer pattern is firstly formed on a substrate in a process for forming a graft polymer pattern.

### (Surface graft polymerization method)

The graft polymer of the present invention is preferred to be that which is formed by a surface graft polymerization method.
Usually, a surface graft polymerization is a method where active species is given onto a high-molecular compound chain forming a solid surface and another monomer is further polymerized using the active species as a starting point to synthesize a graft polymer.

With regard to a surface graft polymerization method for materializing the present invention, any of the known methods mentioned in literatures may be used. For example, in "(Shin Kobunshi Jikkengaku 10 (New Experiments in Polymers, 10)", edited by the Japan Polymer Society, 1994, published by Kyoritsu Shuppan, page 135, an optical graft polymerization method and a plasma irradiation graft polymerization are mentioned as a surface graft polymerization method. Further, in "Kyuchaku Gijutsu Binran (Handbook of Adsorption Technique)", published by NTS K. K., supervised by Takeuchi, published in February 1999, pages 203 and 695, a radiation irradiation graft polymerization by, for example, γ ray and electron beam is mentioned.
With regard to specific methods for the photo-graft polymerization, the methods mentioned in JP-A Nos. 63-092,658, 10-296,895 and 11-119,413 may be used.

In the plasma-irradiation graft polymerization method and the radiation-exposure graft polymerization method, preparation is able to be conducted by the methods described in the above literatures, in Y. Ikeda, et al., Macromolecules, volume 19, page 1804 (1986), etc. To be more specific, surface of a macromolecule such as PET is treated with plasma or electronic ray to generate radicals on the surface and, after that, the activated surface is made to react with a monomer whereupon a graft polymer is able to be prepared.
With regard to a photo-graft polymerization method, there is a method mentioned in JP-A No. 53-017,407 (Kansai Paint) and JP-A No. 2000-212,313 (Dainippon Ink) in addition to the above-mentioned literatures and that is a method where a photopolymerizing composition is coated on the surface of a film substrate and, after that, is irradiated with light while being in contact with a radical polymerization compound to prepare a graft polymer.

With regard to other means for bonding a graft polymer to a substrate, it is also possible, in addition to the above-mentioned methods, to use a method where a reactive functional group such as a trialkoxysilyl group, an isocyanate group, an amino group, a hydroxyl group or a carboxyl group is bonded to a terminal end of a macromolecular compound chain and it is subjected to a coupling reaction with a functional group on the substrate surface, thereby the macromolecular compound chain is introduced onto the substrate surface.

A specific method where a surface graft polymerization method is used in a step for formation of a graft polymer pattern in the present invention will be illustrated.
In the first embodiment of the present invention, a polymerizing compound having the following interacting group A (a functional group which is able to interact with the electro-conductive particles) and a polymerizing compound having a cross-linking group are brought into contact with the substrate surface to apply energy in a pattern form whereby active points are generated on the exposed part of the substrate surface and the active points allowed to react with the polymerizing groups of the polymerizing compound to induce a surface graft polymerization reaction.
Although the contact of those polymerizing compounds to the substrate surface may be carried out by immersing the substrate into a liquid composition containing the polymerizing compound, it is preferred in view of handling and manufacturing efficiency that a liquid composition containing the polymerizing compounds is applied to the substrate surface.

In the second embodiment of the present invention, an interacting group B (a functional group which is able to interact with an electroless plating catalyst or a precursor thereof) is used in place of an interacting group A (a functional group which is able to interact with electro-conductive particles) induced in the first embodiment and, with regard to an electro-conductive raw material to be adhered thereto, electro-conductive particles are used in the first embodiment while, in the second embodiment, an electroless plating catalyst or a precursor is firstly adhered to a substrate and an electro-conductive material layer is formed there by means of electroless plating and, except the above, the same method is used. Therefore, forming graft polymer pattern is illustrated firstly as a representative one and, when it is merely mentioned "interacting group" hereinafter, it stands for "interacting group A or interacting group B".

### (Formation of graft polymer)

In the present invention, a graft polymer which is directly bonded onto the substrate is a graft polymer having an interacting group and a cross-linking group and, due to the presence of an interacting group and a cross-linking group in the polymer structure, it is possible to achieve both functions of adsorption of electro-conductive particles and formation of cross-linking structure.

The graft polymer of the present invention is synthesized by copolymerization of a polymerizing compound having an interacting group with a polymerizing compound having a cross-linking group and, when the above-mentioned surface graft polymerization method is used, a graft polymer which is the copolymer is able to be directly bonded onto the substrate.
With regard to the polymerizing compound having an interacting group and the polymerizing compound having a cross-linking group, although they may be in any of monomer, macromer and polymer having polymerizing group, it is particularly preferred to be a monomer in view of a polymerizing property.

With regard to a monomer having an interacting group and a monomer having a cross-linking group used for formation of the graft polymer, each one kind thereof may be used or plural kinds of monomers may be used together.
In formation of a graft polymer in the present invention, it is necessary to use at least each one member of a monomer having an interacting group and a monomer having a cross-linking group but other copolymerizing monomer may be also used within such an extent that it does not deteriorate the advantages of the present invention.

With regard to the ratio of the monomer component having an interacting group to the monomer component having a cross-linking group in the graft polymer, its molar ratio is preferably from 30:70 to 99:1, more preferably from 50:50 to 95:5 and, still more preferably, from 60:40 to 90:10 in both views of adsorption of electro-conductive particles and formation of cross-linking structure.
Details of the matter concerning adsorption of electro-conductive particles and the matter concerning formation of cross-linking structure will be fully mentioned in the explanation for "forming an electro-conductive particle-adsorbing layer" and "forming a cross-linking structure" which will be illustrated later.

Now, a monomer having an interacting group and a monomer having a cross-linking group which are able to be used for the synthesis of a graft polymer in the present invention will be illustrated in detail.

### - Monomer having an interacting group A -

In the first embodiment, an interacting group of the graft polymer is a functional group having an interacting property corresponding to the electro-conductive particles to be adsorbed with the graft polymer.
In the first embodiment of the present invention, the interacting group A is a functional group which is able to adsorb electro-conductive particles but, when no electro-conductive particle is adsorbed, it may function as a functional group having a structure which is used for a cross-linking reaction.

### - Monomer having an interacting group B -

In the second embodiment, an interacting group of the graft polymer is a functional group having an interacting property corresponding to the electroless plating catalyst or to a precursor thereof.
In the second embodiment of the present invention, the interacting group B is a functional group which capable of adsorbing electroless plating catalyst or its precursor electro-conductive particles but, when catalyst or particles are not adsorbed, the interacting group B may act a functional group having a structure which is used for a cross-linking reaction.

All of the interacting group A and interacting group B in the present invention are preferred to be polar groups and more preferred to be ionic groups. Accordingly, with regard to a monomer having the interacting group (A or B) in the present invention, a monomer having an ionic group (ionic monomer) is advantageously used.

Examples of the above-mentioned ionic monomer are a monomer having positive charge such as ammonium and phosphonium and a monomer having negative charge such as a sulfonic acid group, a carboxyl group, a phosphoric acid group and a phosphonic acid group or a monomer having an acidic group which is able to be dissociated to negative charge.

Examples of the ionic monomer being able to form an ionic group which is advantageously used in the present invention are, as mentioned already, a monomer having positive charge such as ammonium and phosphonium and a monomer having negative charge such as a sulfonic acid group, a carboxyl group, a phosphoric acid group and a phosphonic acid group or a monomer having an acidic group which is able to be dissociated to negative charge.

Specific examples of the ionic monomer which is particularly useful in the present invention are the following monomers. Thus, (meth)acrylic acid or an alkali metal salt and an amine salt thereof, itaconic acid or an alkali metal salt and an amine salt thereof, allylamine or a hydrogen halide salt thereof, 3-vinylpropionic acid or an alkali metal salt and an amine salt thereof, vinylsulfonic acid or an alkali metal salt and an amine salt thereof, styrenesulfonic acid or an alkali metal salt and an amine salt thereof, 2-sulfoethylene (meth)acrylate, 3-sulfopropylene (meth)acrylate or an alkali metal salt and an amine salt thereof, 2-acrylamido-2-methylpropanesulfonic acid or an alkali metal salt and an amine salt thereof, acid phosphoxy polyoxyethylene glycol mono(meth)acrylate or a salt thereof, 2-dimethylaminoethyl (meth)acrylate or a hydrogen halide salt thereof, 3-trimethylammoniumpropyl (meth)acrylate, 3-trimethylammoniumpropyl (meth)acrylamide, N,N,N-trimethyl-N-(2-hydroxy-3-methacryloyloxypropyl)- ammonium chloride, etc. may be used.

With regard to an interacting group, the following monomer having a nonionic polar group may be used as well.
Thus, 2-hydroxyethyl (meth)acrylate, (meth)acrylamide, N-monomethylol (meth)acrylamide, N-dimethylol (meth)acrylamide, N-vinylpyrrolidone, N-vinylacetamide, polyoxyethylene glycol mono(meth)acrylate, etc. are useful.

With regard to a monomer having an interacting group in the present invention, a monomer having an anionic functional group (anionic monomer) such as acrylic acid is particularly preferred.

### - Monomer having a cross-linking group -

A cross-linking group of the graft polymer is a reactive group which reacts with an interacting group or with other functional group of the graft polymer to form a covalent bond and its examples are functional groups such as a hydroxyl group, a methylol group, a glycidyl group, an isocyanate group and an amino group.

With regard to a monomer having a cross-linking group (i.e., a reactive monomer) which is able to be used in the present invention, a known monomer may be appropriately selected and used.
Specific examples of the monomer having a cross-linking group are that having a hydroxyl group such as 2-hydroxyethyl acrylate, 3-hydroxybutyl acrylate, 2-hydroxypropyl acrylate, 3-hydroxypropyl acrylate, 2-hydroxyethyl methacrylate, 3-hydroxybutyl methacrylate, 2-hydroxybutyl methacrylate and 4-hydroxybutyl methacrylate; that having a methylol group such as N-methylolacrylamide, N-methylolmethacrylamide and methylolstearoamide; that having a glycidyl group such as glycidyl acrylate and glycidyl methacrylate; that having an isocyanate group such as 2-isocyanatoethyl methacrylate (for example, Karenzu MOI (trade name, Showa Denko)); and that having an amino group such as 2-aminoethyl acrylate and 2-aminoethyl methacrylate.

With regard to a solvent used for a liquid composition containing the monomer having an interacting group and a monomer having a cross-linking group as such, there is no particular limitation so long as it is able to dissolve such a monomer which is a main component. An aqueous solvent such as water and a water-soluble solvent is preferred and a mixture thereof and an aqueous solvent where surfactant is further added to the solvent are preferred.
A water-soluble solvent is a solvent which is miscible with water in any proportion and examples of such a water-soluble solvent are an alcoholic solvent such as methanol, ethanol, propanol, ethylene glycol and glycerol; an acid such as acetic acid; a ketone solvent such as acetone; and an amide solvent such as formamide.
An applying amount when such a liquid composition is applied on the substrate surface to form a layer to which the liquid composition is applied is preferably 0.1 to 10 g/m² and, particularly preferably, 0.5 to 5 g/m² on the basis of a solid in view of achieving a sufficient adsorbing property of the electro-conductive particles and a uniform applied membrane.

A surfactant is able to be added, if necessary, to the above-mentioned liquid composition. Any surfactant will do so far as it is soluble in a solvent for the liquid composition. Examples of such a surfactant are an anionic surfactant such as sodium n-dodecylbenzenesulfonate; a cationic surfactant such as n-decyltrimethylammonium chloride; and a nonionic surfactant such as polyoxyethylene nonyl phenyl ether (an example of the commercially available product is Emulgen 910 manufactured by Kao), polyoxyethylene sorbitan monolaurate (an example of the commercially available product is Tween 20 (trade name)) and polyoxyethylene lauryl ether.

### (Applying energy in pattern form)

In forming a graft polymer pattern in this process, a monomer having an interacting group and a monomer having a cross-linking property are contacted at the substrate surface and energy is applied in a pattern form. With regard to a means for applying energy used here, there is no particular limitation so far as active sites are able to be generated on the substrate surface and, in view of cost and simplicity of an apparatus, it is preferred to use a method where an actinic radiation is irradiated.
With regard to the actinic radiation, various ones such as infrared ray, visible light, ultraviolet ray and radiant ray may be used and, among them, ultraviolet ray is preferably used since it is suitable for a highly precise pattern exposure. With regard to a radiant ray, there may be used electron beam, X ray, ion beam and far-infrared ray. It is also possible to use g ray, i ray, Deep-UV ray and high-density energy beam (laser beam). With regard to a light source therefor, mercury lamp, metal hydride lamp, xenon lamp, chemical lamp and carbon arc lamp are exemplified as appropriate ones.
When actinic radiation apply energy in a pattern form, any of scanning exposure based on digital data and pattern expose using lith film or mask film may be used.

### (Substrate)

With regard to a substrate used in the present invention, anything may be used so long as it is a plate-shaped material being dimensionally stable and satisfies necessary flexibility, strength, durability, etc. and, depending upon the object of use, it may be appropriately selected.
When a transparent substrate which needs optical transparency, its examples are glass and plastic film (such as cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate and polyvinylacetal).
Examples of a substrate for an electro-conductive pattern material where no transparency is required are a molded product of polyimide resin, bismaleinimide resin, polyphenylene oxide resin, epoxy resin, liquid crystal polymer or polytetrafuoroethylene resin; silicone substrate; paper; paper where plastic is laminated; metal plate (such as aluminum, zinc and copper); and paper or plastic film where the above-mentioned metal is laminated or vacuum-deposited.

In any of the first and the second embodiments of the present invention, a substrate is appropriately selected depending upon the use of an electro-conductive pattern material and the relation with the adsorbed electro-conductive particles and, in view of processing property and transparency, a substance having a surface comprising a macromolecular resin is preferred. To be more specific, any of resin film, a transparent inorganic substrate such as glass where the surface is coated with resin and a compound materials where the surface layer comprised a resin layer is appropriate.
With regard to a substrate where the surface is coated with resin, its representative examples are a layered plate where resin film is adhered on the surface, a substrate which is subjected to a primer treatment and a substrate which is subjected to a hard coat treatment. With regard to compound materials where the surface layer comprises a resin layer, representative examples thereof include resin seal materials provided with an adhesive layer on the back and laminated glass which is a laminated product of glass and resin.

The substrate may be also subjected to surface roughening treatment depending upon its object of use.
For example, in order to further improve the adsorbed amount of electro-conductive particles in electro-conductive pattern or electroless plating catalyst or a precursor thereof per unit area, it is possible that the substrate surface is roughened in advance with the aim of increasing the surface area so that many more ionic groups are introduced.
With regard to a method for roughening the surface of the substrate, known methods appropriate to the material quality of the substrate may be selected. To be more specific, when the substrate is a resin film for example, glow discharge treatment, sputtering, sand blast abrasion method, buff abrasion method, particle adhesion method, particle applying method, etc. may be exemplified. When the substrate is an inorganic material such as glass plate, a method whereby the surface is mechanically roughened may be applied. With regard to a mechanical method, known methods such as ball abrasion method, brush abrasion method, blast abrasion method and buff abrasion method may be used.

### - Substrate surface or intermediate layer -

The substrate in the present invention has a surface to which a graft polymer is able to be directly bonded as mentioned above. In the present invention, the surface itself of the substrate may have such a characteristic or an intermediate layer having such a characteristic may be formed on the substrate surface.

Especially when a graft polymer is synthesized by an optical graft polymerization method, a plasma irradiation graft polymerization method or a radiant ray irradiation graft polymerization method, the intermediate layer is preferred to be a layer having an organic surface and particularly preferred to be a layer of an organic polymer. With regard to an organic polymer, any of synthetic resin such as epoxy resin, acrylate resin, urethane resin, phenol resin, styrene resin, vinyl resin, polyester resin, polyamide resin, melamine resin and formalin resin and natural resin such as gelatin, casein, cellulose and starch may be used. In the optical graft polymerization, the plasma-exposure graft polymerization and the radiant ray irradiation graft polymerization, initiation of the graft polymerization proceeds from hydrogen withdrawal of organic polymer and, therefore, the use of polymer wherefrom hydrogen is apt to be abstracted such as, particularly, acrylate resin, urethane resin, styrene resin, vinyl resin, polyester resin, polyamide resin and epoxy resin is particularly preferred in view of manufacturebility.

### - Layer where polymerization initiating ability is expressed -

In the present invention, it is preferred in view of efficient generation of active point in the graft polymerization that polymerizing compound and polymerization initiator are added to the substrate surface as the compounds which express the polymerization initiating ability by endowing with energy to form an intermediate layer or a layer which expressed the polymerization initiating ability as a substrate surface.
A layer where a polymerizing ability is expressed (hereinafter, it will be sometimes referred to as polymerizing layer) is able to be formed in such a manner that necessary components are dissolved in a solvent in which they are able to be dissolved, placed on the substrate surface by, for example, means of application and hardened by heating or irradiation of light.

### (a) Polymerizing compound

With regard to a polymerizing compound used for a polymerizing layer, there is no particular limitation so long as it has a good adhesiveness to the substrate and is able to be added with a monomer having an interacting group and a monomer having a cross-linking group by endowment with energy such as irradiation of actinic radiation and a hydrophobic polymer having a polymerizing group in a molecule is particularly preferred.
Specific examples of the hydrophobic polymer as such are a diene homopolymer such as polybutadiene, polyisoprene and polypentadiene; a homopolymer of an allyl-containing monomer such as allyl (meth)acrylate and 2-allyloxyethyl methacrylate;
bi- or multi-polymer with styrene, (meth)acrylate and (meth)acrylonitrile containing the above-mentioned diene monomer such as polybutadiene, polyisoprene and polypentadiene or an allyl-containing monomer as a constitutional unit; and
a linear macromolecule or three-dimensional macromolecule having carbon-carbon double bonds in a molecule such as unsaturated polyester, unsaturated polyepoxide, unsaturated polyamide, unsaturated polyacrylate and high-density polyethylene.
In this specification, when acryl and/or methacryl are/is referred to, that may be sometimes referred to as "(meth)acryl".
Amount of the polymerizing compound in the polymerizing layer is within a range of preferably from 0 to 100% by mass and, particularly preferably, from 10 to 80% by mass in terms of solid.

### (b) Polymerization initiator

It is preferred that the polymerizing layer of the present invention contains a polymerization initiator for expressing a polymerizing initiating ability by endowment with energy. With regard to the polymerization initiator used here, known thermal polymerization initiators, photopolymerization initiators, etc. which are able to express the polymerization initiating ability by predetermined energy such as actinic radiation, heating or irradiation of electron beam may be appropriately selected depending upon the object and used. Among them, utilization of photopolymerization having higher reaction rate (polymerization rate) than thermal polymerization is suitable in view of manufacturebility and, therefore, it is preferred to use a photopolymerization initiator.
With regard to the photopolymerization initiator, there is no particular limitation so long as it is active to the irradiating actinic radiation and is able to polymerize a polymerizing compound contained in the polymerizing layer with a monomer having an interacting group and a monomer having a cross-linking group and, for example, a radical polymerization initiator, an anion polymerization initiator and a cation polymerization initiator may be used.

Specific examples of the photopolymerization initiator as such are acetophenones such as p-tert-butyltrichloroacetophenone, 2,2'-diethoxyacetophenone and 2-hydroxy-2-methyl-1-phenylpropan-1-one; ketones such as benzophenone, 4,4'-bisdimethylaminobenzophenone, 2-chlorothioxanthone, 2-methylthioxanthone, 2-ethylthioxanthone and 2-isopropylthioxanthone; benzoin ethers such as benzoin, benzoin methyl ether, benzoin isopropyl ether and benzoin isobutyl ether; and benzyl ketals such as benzyl dimethylketal and hydroxycyclohexyl phenyl ketone.
Amount of the polymerization initiator in the polymerizing layer in terms of solid is within a range of preferably 0.1 to 70% by mass and, particularly preferably, 1 to 40% by mass.

With regard to a solvent used for application of a polymerizing compound and a polymerization initiator, there is no particular limitation so long as it is able to dissolve those components. In view of ease of drying and workability, a solvent whose boiling point is not too high is preferred and, more specifically, the solvent having a boiling point of about 40°C to 150°C may be selected.
Specific examples thereof include acetone, methyl ethyl ketone, cyclohexane, ethyl acetate, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, methanol, ethanol, 1-methoxy-2-propanol, 3-methoxypropanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate and 3-methoxypropyl acetate.
Each of the solvents as such may be used solely or by mixing. It is appropriate that concentration of the solid in an applying solution is 2 to 50% by mass.

The applying amount for forming a polymerizing layer on a substrate is preferably 0.1 to 20 g/m² and, more preferably, 1 to 15 g/m² in terms of the mass after drying in view of expression of a sufficient polymerization initiating ability and maintaining the film property to prevent the removal of the membrane.

As mentioned above, the above-mentioned composition for formation of a polymerizing layer is placed by, for example, means of application on the substrate surface and then the solvent is removed to form a membrane whereby a polymerizing layer is formed and, at that time, it is preferred to harden the layer by conducting heating and/or exposure of light. It is especially preferred that, when a preliminary hardening is conducted by exposure of light after drying with heating, the outcome that the graft polymer formed on the substrate is peeled together with the polymerizing layer is able to be efficiently suppressed since the polymerizing compound is already hardened to some extent. The reason why exposure of light is utilized for the preliminary hardening is the same as that mentioned under the above-mentioned item for photopolymerization initiator.
With regard to the heating temperature and time, the condition by which the applied solvent is able to be well dried may be selected and, in view of the manufacturing adaptability, the temperature of not higher than 100°C and the drying time of within 30 minutes are preferred and it is more preferred to adopt a heating condition within such a range that the drying temperature is 40 to 80°C and the drying time is within 10 minutes.

With regard to irradiation of light which is optionally carried out after heating and drying, examples of the light source are mercury lamp, metal halide lamp, xenon lamp, chemical lamp and carbon arc lamp. Examples of radiant ray are electron beam, X ray, ion beam and far-infrared ray. It is also possible to use g ray, i ray, Deep-UV ray and high-density energy beam (laser beam). From such a view that formation of graft polymer which is conducted thereafter and formation of bond of the active point of the polymerizing layer conducted by endowment with energy to the graft chain are not inhibited, it is preferred to conduct the light irradiation within such an extent that complete radical polymerization does not take place even if the polymerizing compound existing in the polymerizing layer is radically polymerized partially. With regard to the time for the light irradiation, although it varies depending upon the intensity of the light source, it is usually preferred to be within 30 minutes. With regard to the mesure of such a preliminary hardening, an example is that the residual rate of the membrane after washing with a solvent becomes not less than 10% and the residual proportion of the initiator after the preliminary hardening becomes not less than 1%.

One of the suitable embodiments for production of a graft polymer on the substrate in the present invention is an embodiment where a compound having a polymerization initiating ability is bonded to the substrate surface and, using the polymerization initiation site of the compound as such as a starting point, the graft polymer is formed.
With regard to the compound having a polymerization initiating ability which is applicable to the above-mentioned embodiment, an example thereof is a compound having a polymerization initiating site (Y) and a substrate bonding site (Q) being able to initiate the radical polymerization by photocleavage (it will be sometimes referred to as "photocleavage compound (Q-Y)").

As hereunder, a method for bonding the photocleavage compound (Q-Y) to the substrate surface will be illustrated.
In bonding the photocleavage compound (Q-Y) to the substrate surface, a photocleavage compound (Q-Y) is applied onto the substrate to contact to the substrate surface and the functional group (Z) existing on the substrate surface is bonded to the substrate bonding site (Q) so that the photocleavage compound (Q-Y) is introduced onto the substrate surface.

With regard to the functional group (Z) existing on the substrate surface, specific examples thereof are hydroxyl group, carboxyl group and amino group. Such a functional group may be a group which is inherently present on the substrate surface caused by the material for the substrate in silicone substrate and glass substrate or may be a group which is made to exist on the surface by subjecting the substrate surface to a surface treatment such as a corona treatment.

The polymerization initiating site where radical polymerization is able to start by photocleavage (hereinafter, it will be just referred to as "polymerization initiating site (Y)") is a structure containing a single bond which is able to be cleaved by light.
Examples of the single bond cleaved by light are single bonds which are able to be cleaved by utilizing α cleavage of carbonyl, β cleavage reaction, optical Fries rearrangement reaction, cleavage reaction of phenacyl ester, sulfonimide cleavage reaction, sulfonyl ester cleavage reaction, N-hydroxysulfonyl ester cleavage reaction, benzylimide cleavage reaction and cleavage reaction of active halide. As a result of the reactions as such, a single bond which is cleaved by light is cut. Examples of the single bond which is able to be cleaved are C-C bond, C-N bond, C-O bond, C-Cl bond, N-O bond and S-N bond.

The polymerization initiating site (Y) as such containing a single bond which is cleaved by light becomes a starting point of the graft polymerization in the forming the graft polymer pattern and, therefore, when the single bond which is able to be cleaved by light is cleaved, it has a function of generation of radical by said cleavage reaction. With regard to the structure of the polymerization initiating site (Y) having a single bond which is able to be cleaved by light and is able to generate the radical, examples include structures having the following groups.
That is, structures having an aromatic ketone group, a phenacyl ester group, a sulfonimide group, a sulfonyl ester group, a N-hydroxysulfonyl ester group, a benzylimide group, a trichloromethyl group and/or a benzyl chloride group.

When such a polymerization initiating site (Y) is cleaved by exposure of light to generate a radical, the radical functions as a starting point of the graft polymerization whereupon a desired graft polymer is able to be produced in case a compound which is able to be polymerized is present near the radical.
Therefore, when a graft polymer is produced using a substrate where a photocleavage compound (Q-Y) is introduced onto the surface, it is necessary to use an exposure to light at the wavelength by which the polymerization initiating site (Y) is able to be cleaved as a means for applying energy.

With regard to a substrate bonding site (Q), it is constituted from a reactive group which is able to bond by the reaction with the functional group (Z) existing on the substrate surface and specific examples of such a reactive group are as follows.

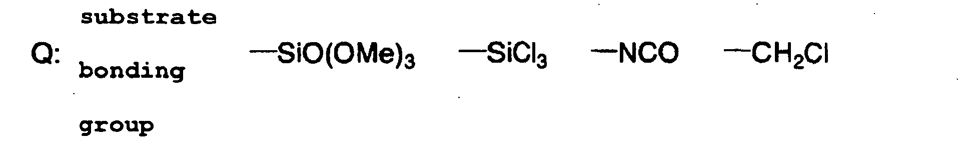

The polymerization initiating site (Y) and the substrate bonding site (Q) may be directly bonded or may be bonded via a connecting group. With regard to the connecting group, a connecting group containing atoms selected from carbon, nitrogen, oxygen and sulfur is listed and its specific examples are saturated carbon group, aromatic group, ester group, amide group, ureido group, ether group, amino group and sulfonamide group. The connecting group may further have a substituent and examples of such an introducible substituent are an alkyl group, an alkoxy group and halogen atom.

Specific examples of the compound (Q-Y) having a substrate bonding site (Q) and a polymerization initiating site (Y) (exemplified compounds 1 to 16) will be shown as hereunder together with the cleaving site although the present invention is not limited thereto.

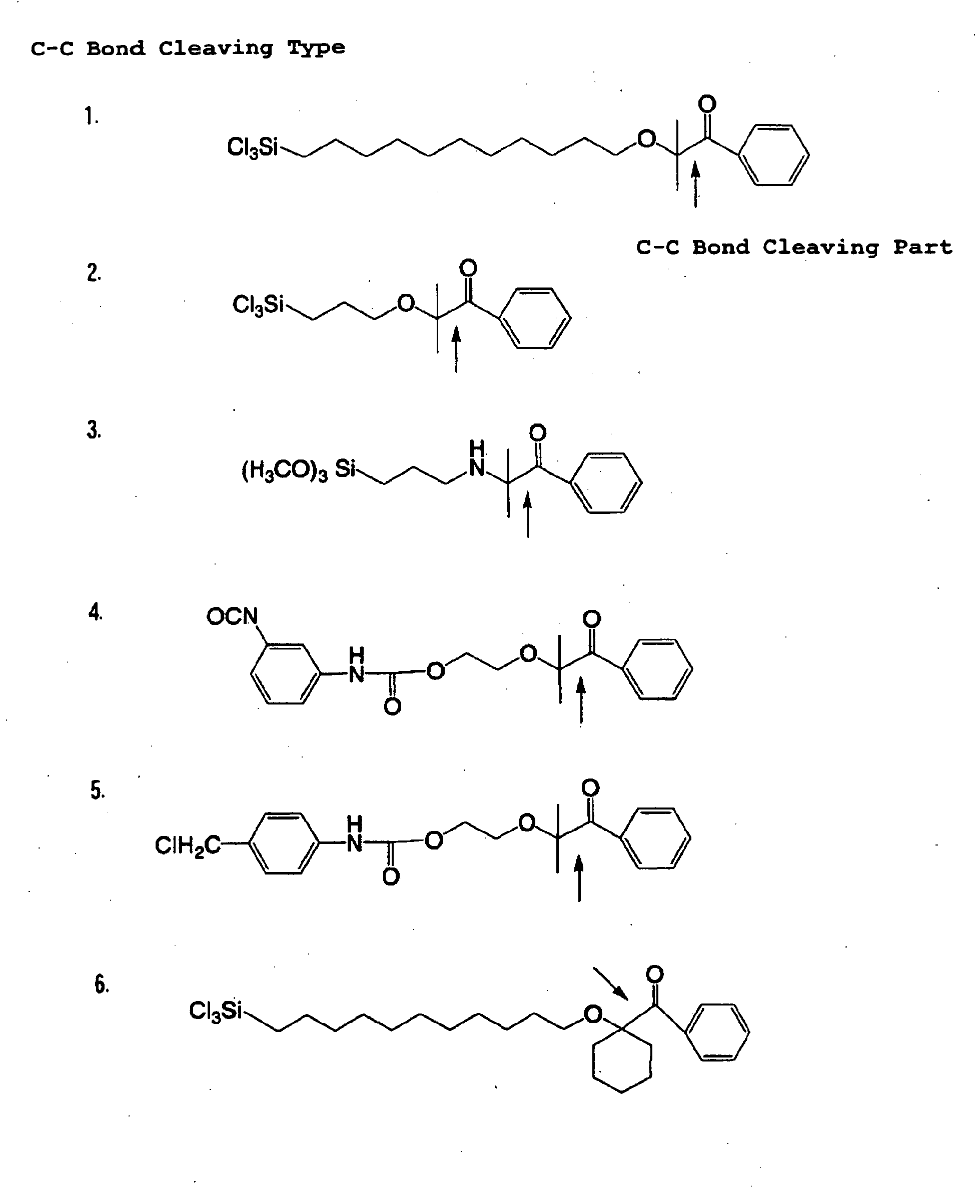

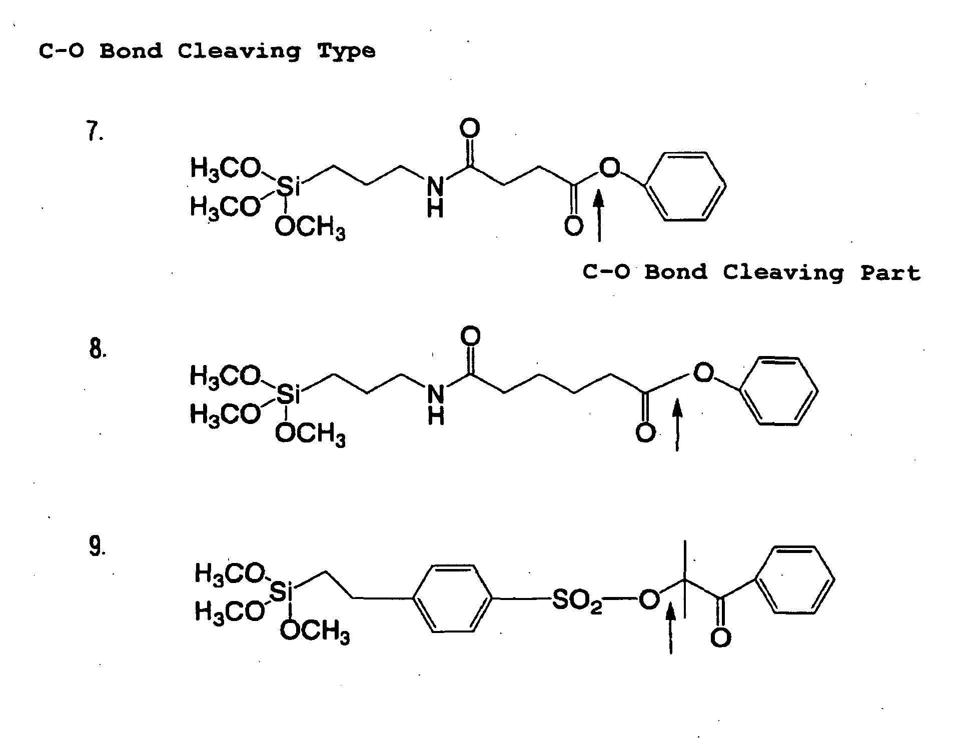

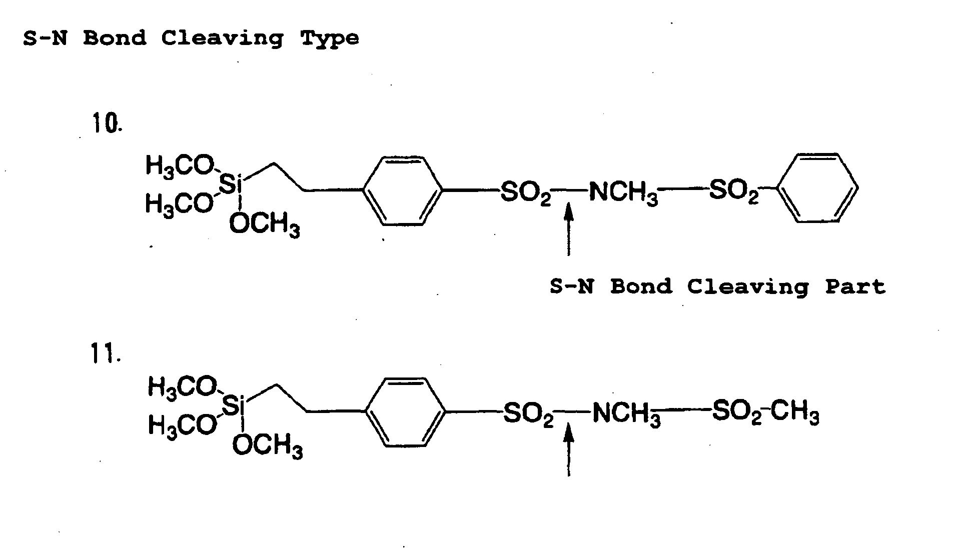

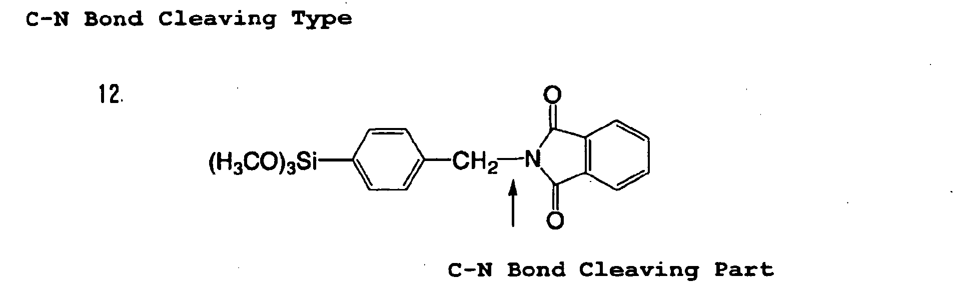

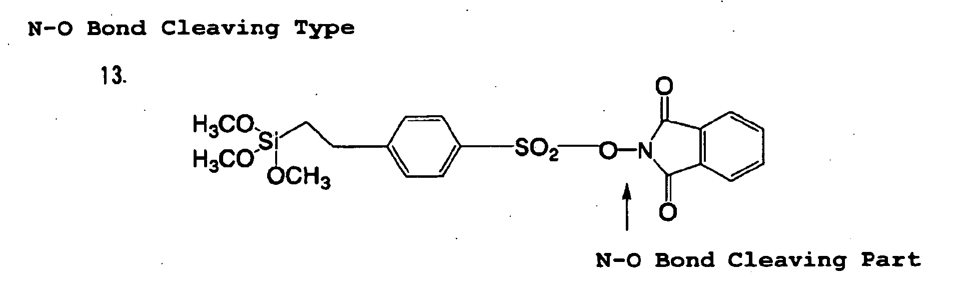

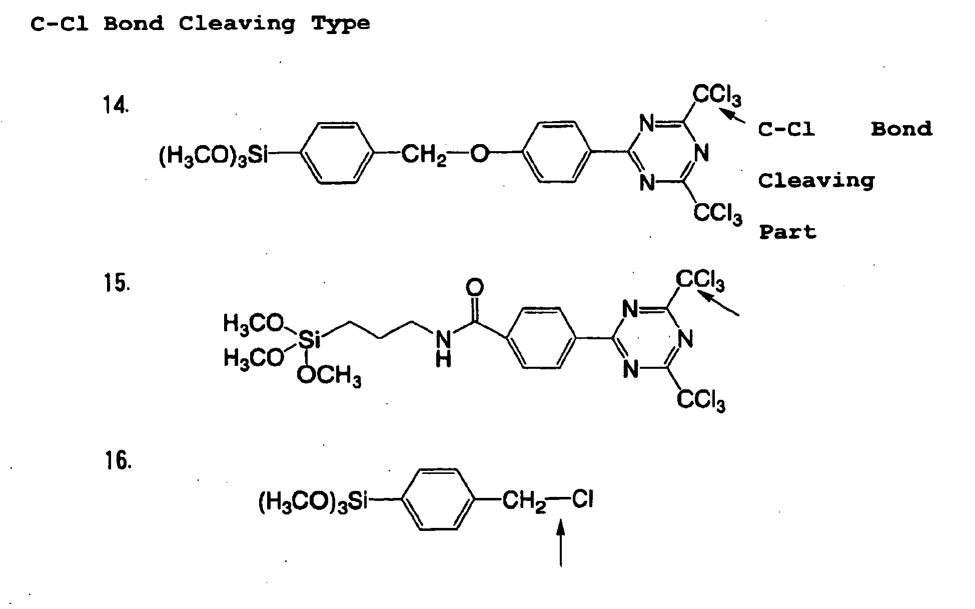

With regard to a specific method for bonding the photocleavage compound (Q-Y) to a functional group (Z) existing on the substance, a method where the photocleavage compound (Q-Y) is dissolved or dispersed in an appropriate solvent such as toluene, hexane or acetone and the solution or the dispersion is applied onto the surface of the substrate, a method where the substrate is immersed in the solution or the dispersion, etc. may be adopted. As a result of those methods, a substrate surface into which the photocleavage compound (Q-Y) is introduced is prepared.
With regard to the concentration of the photocleavage compound (Q-Y) in the solution or the dispersion at that time, it is preferably 0.01% by mass to 30% by mass and, particularly preferably, 0.1% by mass to 15% by mass. Liquid temperature upon contacting is preferably 0°C to 100°C. With regard to the contacting time, it is preferably 1 second to 50 hours and, more preferably, 10 seconds to 10 hours.

When a substrate where a photocleavage compound (Q-Y) is introduced onto the surface prepared as such is used, there is used a method where a monomer having an interacting group and a monomer having a cross-linking group are contacted to its surface and a pattern exposure to light is conducted so that the polymerization initiation site (Y) of the exposed part is cleaved and a graft polymer is produced using the site as a starting point to form a graft polymer pattern.
It is also possible to form a graft polymer pattern by the following method.
Thus, first, the substrate surface into which a photocleavage compound (Q-Y) is introduced is subjected to a pattern exposure to light along the region where the formation of the graft polymer is not desirable and the compound (Q-Y) bounded to the substrate surface is photocleavaged to inactivate the polymerization initiation ability ,so that a region where the polymerization initiation can be performed and a reagion where the polymerization initiation is inactivated are formed on the substrate surface. Then a monomer having an interacting group and a monomer having a cross-linking group are contacted at the substrate surface in the regions where polymerization initiation is possible and the regions where polymerization initiation ability is inactivated are formed and then all the surface is exposed to light whereby a graft polymer is produced only in the regions where polymerization initiation is possible and, as a result, a graft polymer pattern is formed.

As such, a graft polymer pattern in which a graft polymer is bonded in a pattern form on the substrate is formed and, after that, the following (2) forming an adsorbing layer for electro-conductive particles is conducted in the first embodiment while, in the second embodiment, the following (2') forming a layer containing electroless plating catalyst is conducted.

### < (2) Forming a layer for adsorption of electro-conductive particles >

In forming a layer for adsorption of electro-conductive particles, electro-conductive particles are adsorbed with the interacting group of the graft polymer formed in a pattern form whereupon the layer for adsorption of electro-conductive particles in a pattern form is formed.
When the electro-conductive particles adsorbed by the interacting group of the graft polymer are explained by taking an ionic group as an example of interacting groups, the particles substantially regularly arrayed in a monolayer state or each of fine particles in a nano level is adsorbed by each ionic group of the long graft polymer chain, as a result, the particles may be arrayed in multi-layers is arranged depending upon the existing state of the ionic groups.

Now, the electro-conductive particles which are able to be used in the present invention will be more specifically illustrated.
With regard to the electro-conductive particles, it is preferred to use fine particles of at least one member selected from electro-conductive metal particles and metal oxide particles, metal oxide particles and fine particles of metal compound having semiconductor property and fine particles of electro-conductive resin.
With regard to the above-mentioned metal particles and metal oxide particles, those within a broad range are able to be used so long as they comprise powder of electro-conductive metal or metal oxide where specific resistance is not more than 1 × 10³ Ω·cm and specific examples thereof are single substances and alloy of silver (Ag), gold (Au), nickel (Ni), copper (Cu), aluminum (Al), tin (Sn), lead (Pb), zinc (Zn), iron (Fe), platinum (Pt), iridium (Ir), osmium (Os), palladium (Pd), rhodium (Rh), ruthenium (Ru), tungsten (W) and molybdenum (Mo) and also tin oxide (SnO₂), indium oxide (In₂O₃), ITO (indium tin oxide) and ruthenium oxide (RuO₂).
It is also possible to use metal oxide particles and metal compound particles having the above characteristic as semiconductor and examples thereof are oxide semiconductor particles such as In₂O₃, SnO₂, ZnO, CdO, TiO₂, CdIn₂O₄, Cd₂SnO₂, Zn₂SnO₄ and In₂O₃-ZnO, particles using a material where impurities adaptable thereto are made into a dopant, particles of a spinel type compound such as MgInO and CaGaO, particles of an electro-conductive nitride such as TiN, ZrN and HfN and particles of an electro-conductive borate such as LaB.
Each of those electro-conductive particle members may be used solely or two or more kinds thereof may be used jointly. It is also possible that plural materials may be previously mixed for achieving the desired electric conductivity.
Since electro-conductive particles are ionically adsorbed with the interacting group as a preferred embodiment, obviously particle size and adsorbed amount are limited by surface charge of electro-conductive particles and numbers of ionic group.

Particle size of the electro-conductive particles are able to be selected depending upon object and use and, in view of expression of electric conductivity and adsorbing property, it is usually preferably within a range of 0.1 nm to 1 µm, more preferably within a range of 1 nm to 300 nm and, particularly preferably, within a range of 5 nm to 100 nm.

### - Relation between the interacting group (ionic group) of graft polymer and the electro-conductive particles -

When the graft polymer formed on the substrate has an interacting group (ionic group) having anionic property such as carboxyl group, sulfonic acid group or phosphonic acid group, the interacting group becomes to have a negative charge and, therefore, when cationic electro-conductive particles having positive charge are adsorbed therewith, a layer where electro-conductive particles are adsorbed therewith is formed.

With regard to the electro-conductive particles having a cationic property as such, fine particles of metal (oxide) having a positive charge may be exemplified. Fine particles having a positive charge on the surface in a high density are able to be prepared by, for example, a method by Toru Yonezawa, et al. such as the method mentioned in T. Yonezawa, Chemistry Letters, 1999, page 1061; T. Yonezawa, Langumuir, 2000, vol. 16, 5218; and Toru Yonezawa, Polymer Preprints, Japan, vol. 49, 2911 (2000). Yonezawa, et al. show that a metal-sulfur bond is utilized whereby it is possible to form a metal particle surface which is chemically modified in a high density with a functional group having a positive charge.

On the other hand, when the graft polymer formed on the substrate has an interacting group (ionic group) which is a cationic group such as ammonium group as mentioned in JP-A No. 10-296,895, the interacting group becomes to have a positive charge and, therefore, when electro-conductive particles having a positive charge is adsorbed therewith, a layer where electro-conductive particles are adsorbed is formed.
With regard to the electro-conductive particles which are negatively charged, particles of gold or silver prepared by a citric acid reduction may be exemplified.

With regard to a method for adsorption of the electro-conductive particles with an interacting group (ionic group) of the graft polymer, its examples are a method where a liquid in which the electro-conductive particles are dissolved or dispersed is applied onto the substrate surface on which the graft polymer pattern is formed and a method where a substrate in which the graft polymer patter is formed is immersed in a liquid in which the electro-conductive particles are dissolved or dispersed.
In any of the cases of applying and immersion, an excessive amount of the electro-conductive particles is supplied and a sufficient introduction by ionic bond is done into the interacting group (ionic group) of the graft polymer and, therefore, the contacting time between the solution or the dispersion and the surface where the graft polymer is formed is preferably from about 10 seconds to 24 hours and, more preferably, from about 1 minute to 180 minutes.
The electro-conductive particles are preferred to be bonded in the maximum amount which is able to be adsorbed with the hydrophilic group of the graft polymer and, in view of ensuring the electric conductivity, dispersed concentration of the dispersion containing the electro-conductive particles is about 0.001 to 20% by mass.

When the electro-conductive particles are adsorbed with the interacting group of the graft polymer which is directly bonded to the substrate as such, it is now possible to give a layer where electro-conductive particles are adsorbed in a pattern form.
Although the thickness of the electro-conductive particle-adsorbed layer may be selected depending upon the object, it is usually preferably within a range from 0.001 µm to 10 µm, more preferably within a range from 0.01 µm to 5 µm and, most preferably, within a range from 0.1 µm to 2 µm in view of anti-scratching (layer strength) and transparency.

### < (2') Forming a layer containing electroless plating catalyst >

In forming a layer containing electroless plating catalyst which is carried out after the above-mentioned forming of a graft polymer pattern in the second embodiment of the present invention, an electroless plating catalyst or a precursor thereof is applied to the interacting group B of the graft polymer being bonded onto the substrate in a pattern form as a result of the above-mentioned forming a graft polymer pattern whereby a layer containing an electroless plating catalyst in a pattern form is formed.

### - Electroless plating catalyst -

With regard to the electroless plating catalyst used in this process (2'), it is mostly a 0-valent metal and its examples are Pd, Ag, Cu, Ni, Al, Fe and Co. In the present invention, Pd and Ag are particularly preferred in light of their handling characteristics and high catalytic ability. With regard to a method for fixing the o-valent metal to a graft polymer, there is used a method where metal colloid which is adjusted so as to conduct an interaction to the interacting group in the graft polymer is applied to the graft polymer. In general, the metal colloid can be prepared by reducingthe metal ion in a solution in which a surfactant having a charge or a protective agent having a charge is present. The charge of the metal colloid can be adjusted by the surfactant or the protective agent used here, and the metal colloid having the adjusted charge is subjected to an interaction with the interacting group of the graft polymer, so that the metal colloid (electroless plating catalyst) can be adsorbed by the graft polymer.

### - Precursor of electroless plating catalyst -

With regard to a precursor of electroless plating catalyst used in the present invention, any compound may be used without particular limitation so long as the compound which can bean electroless plating catalyst by chemical reaction. Mostly, the metal ion of a 0-valent metal used in the above-mentioned electroless plating catalyst is used. The metal ion which is a precursor of the electroless plating catalyst becomes a 0-valent metal which is an electroless plating catalyst by a reduction reaction. After being applied to a substrate, a metal ion which is a precursor of an electroless plating catalyst may be converted to a 0-valent metal by a separate reduction reaction before dipping into an electroless plating bath or it may be dipped into an electroless plating bath in a form of a precursor of an electroless plating catalyst and is converted to metal (electroless plating catalyst) by a reducing agent in the electrolytic plating bath.

Practically, a metal ion which is a precursor of the electroless plating catalyst is applied to a graft polymer in a state of metal salt. With regard to the metal salt used therefor, there is no particular limitation so long as it is soluble in an appropriate solvent and is dissociated into metal ion and base (anion) and its examples are M(NO₃)ₙ, MClₙ, M_{2/n}(SO₄) and M_{3/n}(PO₄) (M is an n-valent metal atom). With regard to the metal ion, that in which the above-mentioned metal salt is dissociated is able to be used advantageously. Specific examples thereof are Ag ion, Cu ion, Al ion, Ni ion, Co ion, Fe ion and Pd ion are preferable in terms of catalytic ability.

With regard to a method where metal colloid which is an electroless plating catalyst or a metal salt which is a precursor of the electroless plating catalyst is applied onto the graft pattern, the metal colloid is dispersed in an appropriate dispersing medium or the metal salt is dissolved in an appropriate solvent to prepare a solution containing a dissociated metal ion and the resulting solution is applied onto the surface of the substrate being bonded to the graft polymer or the substrate to which the graft polymer is bonded is immersed in the solution. As a result of contacting the solution containing the metal ion, the metal ion is able to be adsorbed therewith by means of an ion-to-ion interaction or a dipole-to-ion interaction or the metal ion is able to be impregnated in a layer containing the graft polymer. From a view that such an adsorption or impregnation is sufficiently carried out, concentration of the metal ion or the metal salt in the solution to be contacted is preferably within a range of 0.01 to 50% by mass and, more preferably, within a range of 0.1 to 30% by mass. Contacting time thereof is preferably about 1 minute to 24 hours and, more preferably, about 5 minutes to 1 hour.

It is now possible that, when an electroless plating catalyst or a precursor thereof is adsorbed or impregnated with an interacting group of the graft polymer directly bonded to the substrate in a pattern form as such, a layer containing an electroless plating catalyst in a pattern form is prepared.
Thickness of the layer containing an electroless plating catalyst may be selected depending upon the object and, in view of resistance to scratch (layer strength) and transparency, it is usually preferably within a range of 0.001 µm to 10 µm, more preferably within a range of 0.01 µ to 5 µm and, most preferably, within a range of 0.1 µm to 2 µm.

### < (3) Forming a cross-linking structure >

In forming a cross-linking structure, the layer where electro-conductive particles are adsorbed formed by the above process for adsorption of electro-conductive particles or a layer where electroless plating catalyst is contained formed by the above process for formation of layer where the electroless plating catalyst is contained is endowed with energy whereupon a cross-linking structure is formed in said layer where the electro-conductive particles are adsorbed or in the layer where electroless plating catalyst is contained.

In the process (3) for formation of a cross-linking structure, it may be an embodiment (3-1) where interacting group where no electro-conductive particles or electroless plating catalyst are/is adsorbed is used for formation of a cross-linking structure or may be an embodiment (3-2) where the interacting group is used only for adsorption of the electro-conductive particles or the electroless plating catalyst and is not used for formation of the cross-linking structure.

Examples of the graft polymer used in the formation of a cross-linking structure mentioned in the above (3-1) and (3-2) are as follows.
In the case of (3-1), a graft polymer which is a bi-polymer of a monomer having a carboxyl group and a monomer having a glycidyl group is exemplified.
In the case of (3-2), a graft polymer which is a ter-polymer of a monomer having a carboxyl group, a monomer having a hydroxyl group and a monomer having an isocyanate group is exemplified, or a graft polymer which is a bi-polymer of a monomer having a carboxyl group and a monomer which reacts with N-methylolacrylamide or the like to form a cross-linking structure.

The cross-linking reaction is started by endowing the electro-conductive particle-adsorbing layer or the electroless plating catalyst-containing layer with energy. Examples of the mode of applying energy are heating, irradiation with light, irradiation with ultrasonic wave and irradiation with electron beam.
In the present invention, an embodiment where a cross-linking structure is formed by heating is preferred. A specific example thereof is a reaction of a carboxyl group which is an interacting group of the graft polymer with a glycidyl group which is a cross-linking group.

When endowment with energy is carried out by heating, examples of the heating means are heating by an oven or a hot plate using a heater and heating by means of light-heat conversion using infrared ray or visible light.
Although the heating treatment may vary depending upon the type of the graft polymer prepared, it is carried out by heating at 50°C to 300°C for about 0.1 second to 60 minutes.
When endowment with energy is conducted by irradiation of light, examples of the means for irradiation of light are various kinds of light sources from ultraviolet to visible regions such as mercury lamps from low voltage to high voltage, metal halide lamp and xenon lamp.

As such, in the first embodiment, a cross-linking structure is formed in a layer where electro-conductive particles are adsorbed. A cross-linking rate in the cross-linking structure is able to be estimated by an increasing rate of the mass after immersing the electro-conductive particle-adsorbing layer where the cross-linking structure is formed into a solvent. The solvent used here is selected from solvents having the highest affinity to the electro-conductive particle-adsorbing layer where the cross-linking structure is formed and, when the graft polymer which constitutes the electro-conductive particle-adsorbing layer is produced from an ionic monomer or a monomer having a polar group, it is able to be selected from water, N,N-dimethylacetamide, etc.
The mass increasing rate of the electro-conductive particle-adsorbing layer where the cross-linking structure is formed is preferably not more than 30%, more preferably not more than 10% and, particularly preferably, not more than 5%.
When the substrate where such an electro-conductive particle-adsorbing layer is formed has no affinity to a solvent used for estimation of the cross-linking rate, it is also possible to calculate the mass increasing rate of the electro-conductive particle-adsorbing layer where the cross-linking structure is formed even when it is immersed in the solvent together with the substrate.

On the other hand, in the second embodiment, a cross-linking structure in the electroless plating catalyst-containing layer is formed in the similar manner as above. The cross-linking structure formed by this step are determined by the cross-linking ratio between graft polymers (whether how many cross-links are generated between graft polymer and graft polymer) and by the distance between the cross-linking sites. The degree of the cross-linking affects the ease of the electroless plating and the degree of the adhesive ability in the electroless planting step (4).
Degree of the cross-linking in the present invention can be estimated by the degree of swelling of a cross-linking membrane to a solvent after a cross-linking is conducted by heating or the like under the state where no electrolytic plating catalyst, etc. are applied. With regard to the solvent in that case, a solvent having the highest affinity to the cross-linking membrane is selected. When a graft polymer is prepared from a monomer having a high affinity to water such as to acrylic acid or acrylamide, then water, methanol, acetonitrile or the like is selected as a solvent. Degree of swelling for achieving the advantages of the present invention is within a range of 0.1 to 100% and, preferably, 1.0 to 10% in terms of mass fraction.

As illustrated hereinabove, in the method for the manufacture according to the first embodiment of the present invention, an electro-conductive pattern material is able to be manufactured by the above-mentioned processes (1) to (3).
In the electro-conductive pattern material prepared in the first embodiment of the present invention, the graft polymer is directly bonded onto the substrate and, therefore, there is an electro-conductive particle-adsorbing layer where electro-conductive particles are uniformly adsorbed in an electrostatic manner with the interacting group of the graft polymer in high density. Further, in this embodiment, a layer where electro-conductive particles are adsorbed with an interacting group of the graft polymer either in a state of single layer or in a state of multiple layers whereby a high electric conductivity is able to be achieved. Moreover, since a cross-linking structure is formed in the electro-conductive particle-adsorbing layer, the electro-conductive particles are strongly fixed in the electro-conductive particle-adsorbing layer whereby peeling of the electro-conductive particles caused by the environment where the electro-conductive layer is used does not happen, no fear of breakage of wire is noted and durability of electrical conductivity is excellent.

With regard to the use of the electro-conductive pattern material as such, it is able to be used for formation of various circuits and, since it is particularly possible to form a very small electro-conductive pattern, a wide range of uses including formation of circuits including micromachine and Very Large Scale Intergration. In addition to those, various uses such as for fine wiring, high-density magnetic disk, magnetic head, magnetic tape, magnetic sheet and magnetic disk are able to be expected and its application range is broad.

In the second embodiment of the present invention, the material having an electroless plating catalyst-containing layer (a layer containing an electroless plating catalyst or a precursor thereof) where the cross-linking structure is formed in the previous process is further subjected to an electroless plating process (4) whereupon an electro-conductive pattern is formed.

### < Electroless plating >

In this process, an electroless plating is carried out for an electroless plating catalyst-containing layer (a layer containing an electroless plating catalyst or a precursor thereof) whereupon metal is separated in an electroless plating catalyst-containing layer in high density and an electro-conductive pattern is able to be formed. The separated metal is strongly held by a cross-linking structure of the graft polymer.

### - Electroless plating -

An electroless plating is an operation where metal is deposited by means of a chemical reaction using a solution where ion of metal which is to be deposited for plating is dissolved therein.
When an electroless plating catalyst-containing layer contains an electroless plating catalyst for example, the electroless plating in this process is carried out in such a manner that the substrate where said layer is formed is washed with water to remove an excessive electroless plating catalyst (metal) and then it is immersed in an electroless plating bath. With regard to the electroless plating bath, a commonly known electroless plating bath may be used.
When the electroless plating catalyst-containing layer contains an electroless catalyst precursor and is dispersed in an electroless plating bath under such a state that the electroless plating catalyst precursor is adsorbed or impregnated with the graft polymer, the substrate is washed with water to remove an excessive precursor (such as metal salt) and then it is immersed in an electroless plating bath. In that case, reduction of the precursor and succeeding electroless plating are carried out in the electroless plating bath. With regard to the electroless plating bath used here, it is also possible to use the commonly known electroless plating bath the same as above.

In the common composition for an electroless plating bath, its main components are 1. metal ion for plating, 2. reducing agent and 3. additive (stabilizer) for improving the stability of the metal ion. In addition to them, the plating bath may also contain known additives such as a stabilizer for a plating bath.
With regard to the metal used for an electroless plating bath, there have been known copper, tin, lead, nickel, gold, palladium and rhodium and, among them, copper and gold are particularly preferred in view of electric conductivity. There are optimum reducing agents and additives depending upon each of the above-mentioned metals. For example, an electroless plating bath for copper contains Cu(SO₄)₂ as a copper salt, HCOH as a reducing agent and a chelating agent such as EDTA or Rochelle salt for copper ion as an additive. A plating bath used for an electroless plating of CoNiP contains cobalt sulfate or nickel sulfate as a metal salt, sodium hyposulfite as a reducing agent and sodium malonate, sodium malate or sodium succinate as a complexing agent. An electroless bath for palladium contains (Pd(NH₃)₄)Cl₂ as metal ion, NH₃ or H₂NNH₂ as a reducing agent and EDTA as a stabilizer. Those plating bathes may also contain the components which are other than the above-mentioned ones.

Thickness of the electro-conductive membrane formed as such is able to be controlled by concentration of metal salt or metal ion in the plating bath, immersing time into the plating bath or temperature of the plating bath and, in view of electric conductivity, it is preferably not less than 0.5 µm and, more preferably, not less than 3 µm. Time for immersing into the plating bath is preferably about 1 minute to 3 hours and, more preferably, about 1 minute to 1 hour.

In the electro-conductive pattern prepared as such, it was confirmed by observation of its cross section under an SEM that fine particles of electroless plating catalyst and plating metal are densely dispersed in the surface graft membrane and further that relatively big particles are separated thereon. Since the interface is a hybridized state of the graft polymer with the fine particles, the adhesiveness was good even when the difference between concaves and convexes of the interface between the substrate (organic component) and the inorganic substance (electroless plating catalyst or plating metal) is 100 nm or less.

### < Electric plating >

In the present invention, a process for conducting an electric plating (an electric plating process) may be available after conducting the above-mentioned electroless plating process.
In this process, after the above-mentioned electroless plating, an electric plating may be carried out using the electro-conductive pattern formed in that process is used an electrode. As a result, an electro-conductive pattern having an excellent adhesiveness to the substrate is used as a base and a new electro-conductive pattern having any thickness is able to be easily formed there. When such a process is added, the electro-conductive pattern is able to be formed in the thickness coping with the object and that is advantageous for applying the electro-conductive pattern prepared by the present invention to various uses where a high electric conductivity is demanded.
With regard to a method for electric plating, methods which have been known already may be used. Examples of the metal used in the electric plating of this process are copper, chromium, lead, nickel, gold, silver, tin and zinc and, in view of electric conductivity, copper, gold and silver are preferred and copper is more preferred.

Thickness of the electro-conductive pattern prepared by the electric plating varies depending upon the use and is able to be controlled by adjustment of concentration of the metal contained in the plating bath, immersing time, current density, etc. Membrane thickness when used for common wiring, it is preferably not less than 0.3 µm and, more preferably, not less than 3 µm in view of electric conductivity.

In accordance with each of the processes concerning the manufacturing method of the present invention as mentioned hereinabove, it is now possible to manufacture an electro-conductive pattern material.

In the electro-conductive pattern material prepared by the present invention, a graft polymer is directly bonded onto the substrate and, as a result, metal which is separated by electroless plating is able to be adsorbed with said graft polymer in an electrostatic manner uniformly and in high density. Moreover, in the present invention, no binder is used and, in addition, a layer where metal separated by the electroless plating is separated in a single-layered state or a multi-layered state is formed on the graft polymer. As a result, the electro-conductive pattern material prepared by the present invention is able to achieve a high electric conductivity. Further, a cross-linking structure is formed in the layer containing the electrolytic plating catalyst whereby the electroless plating catalyst, etc. contained in the layer are strongly fixed in the layer containing the electroless plating metal and, therefore, the metal (electro-conductive material) separated by the electroless plating conducted thereafter is strongly held by a cross-linking structure and there is no deterioration of retaining property of the metal part and durability thereof caused by environment, etc. where the electro-conductive material is used.

With regard to the use of the electro-conductive pattern material as such, the material is able to be used for various circuit formation uses and, particularly since it is able to form a fine electro-conductive pattern, a wide use including circuit formation of micromachine and Very Large Scale Integration is able to be expected. In addition to those, various uses such as for fine wiring, high-density magnetic disk, magnetic head, magnetic tape, magnetic sheet and magnetic disk are able to be expected and its application range is broad.

### Examples

The present invention will now be more specifically described by way of the following Examples although the present invention is not limited thereto.

### [Example 1]

### [(1) Forming graft polymer pattern]

PET (188 µm, manufactured by Toray) was used as a substrate and the following photopolymerizing composition was applied on its surface using a rod bar No. 18 followed by drying at 80°C for 2 minutes to form an intermediate layer having a membrane thickness of 6 µm.

### < Photopolymerizing composition >

- Allyl methacrylate/methacrylic acid copolymer 2 g (copolymerizing molar ratio: 80/20; average molecular weight: 100,000)
- Ethylene oxide-modified bisphenol A diacrylate 4 g
- 1-Hydroxycyclohexyl phenyl ketone 1.6 g
- 1-Methoxy-2-propanol 16 g

### - Formation of graft polymer -

A 5% by mass aqueous solution (5 ml) of monomers comprising acrylic acid and glycidyl methacrylate (molar ratio: 80/20) was dropped onto an intermediate layer, a quartz plate was covered thereon and the aqueous monomer solution was uniformly sandwiched between the intermediately layer and the quartz plate. A pattern mask (NC-1 manufactured by Toppan Printing) was closely adhered on the quartz plate using a clip and then exposure to light was conducted for 5 minutes from the upper part of the pattern mask using an exposure machine (UVX-0251651LP01 manufactured by Ushio Denki). As a result, a substrate where a graft polymer comprising a copolymer of acrylic acid and glycidyl methacrylate was bonded onto the substrate surface in a pattern form was prepared.
The substrate where such a graft polymer pattern was prepared is called a substrate A.

### [(2) Forming a layer where electro-conductive particles are adsorbed]

The substrate A was immersed in an Ag particle dispersion having a positive charge was prepared as follows and, after that, the surface was well washed with flowing water to remove excessive particle dispersion whereupon an electro-conductive particle-adsorbing layer where the electro-conductive particles are adsorbed was prepared.

### (Preparation of Ag particle dispersion)

To 50 ml of an ethanolic solution (5 mmol/1) of silver perchlorate was added 3 g of bis(1,1-trimethylammonium decanoylaminoethyl) disulfide and 30 ml of a sodium borohydride solution (0.4 mol/l) was gradually dropped thereinto with vigorous stirring to reduce the ion to give a dispersion of silver particles coated with quaternary ammonium. When size of the silver particles was measured under an electron microscope, the average particle size was 5 nm.

### [(3) Forming a cross-linking structure]

The substrate A where the electro-conductive particle-adsorbing layer was formed was heated at 140°C for 5 minutes using a hot plate (type: T2B; manufactured by Bamstead) so that carboxyl and glycidyl groups of the graft polymer were cross-linked whereupon a cross-linking structure was formed in the electro-conductive particle-adsorbing layer.
As such, an electro-conductive pattern material A of Example 1 was prepared.

### [Example 2]

### [(1) Forming a graft polymer pattern]

### (Synthesis Example 1: Synthesis of compound A)

Synthesis of the above-mentioned exemplified compound 1 was carried out according to the following two processes. Illustration will be made for showing a scheme for each process.

### 1. Process 1 (Synthesis of the compound a)

1-Hydroxycyclohexyl phenyl ketone (24.5 g, 0.12 mol) was dissolved in a mixed solvent of 50 g of DMAc and 50 g of THF and 7.2 g (0.18 mol) of NaH (60% in oil) was gradually added thereto on an ice bath. 11-Bromo-1-undecene (95%) (44.2 g, 0.18 mol) was dropped thereinto and the reaction was carried out at room temperature. The reaction finished within 1 hour. The reaction solution was poured into ice water and extracted with ethyl acetate to give a mixture containing a compound a as a yellow solution. The mixture (37 g) was dissolved in 370 ml of acetonitrile and 7.4 g of water was added thereto. p-Toluenesulfonic acid monohydrate (1.85 g) was added thereto followed by stirring at room temperature for 20 minutes. The organic layer was extracted with ethyl acetate and the solvent was evaporated from the extract. The residue was subjected to a column chromatography (filler: Wakogel C-220; developer: ethyl acetate/hexane = 1/80) whereupon the compound a was isolate.
Synthetic scheme is shown below.

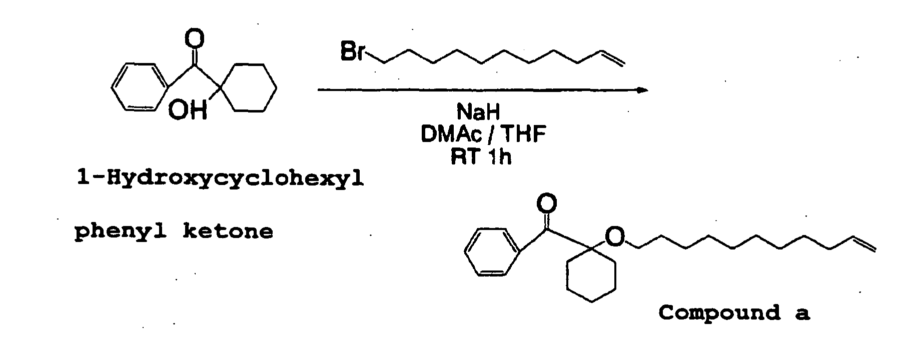

¹H-NMR (300 MHz, CDCl₃) δ = 1.2 to 1.8 (mb, 24H), 2.0 (q, 2H), 3.2 (t, J = 6.6, 2H), 4.9 to 5.0 (m, 2H), 5.8 (ddt, J = 24.4, J = 10.5, J = 6.6, 1H), 7.4 (t, J = 7.4, 2H), 7.5 (t, J = 7.4,1H), 8.3 (d, 1H)

### 2. Process 2 (Synthesis of the compound A by hydrosilylation of the compound a)

To 5.0 g (0.014 mol) of the compound a was added 2 drops of Speir catalyst (H₂PtCl₆.6H₂O/2-PrOH, 0.1 ml/l) and then 2.8 g (0.021 mol) of trichlorosilane was dropped thereinto on an ice bath followed by stirring. After 1 hour, 1.6 g (0.012 mol) of trichlorosilane was dropped thereinto and the mixture was returned to room temperature. The reaction finished after 3 hours. After finishing the reaction, unreacted trichlorosilane was evaporated *in vacuo* to give a compound A.
Synthetic scheme is shown as follows.

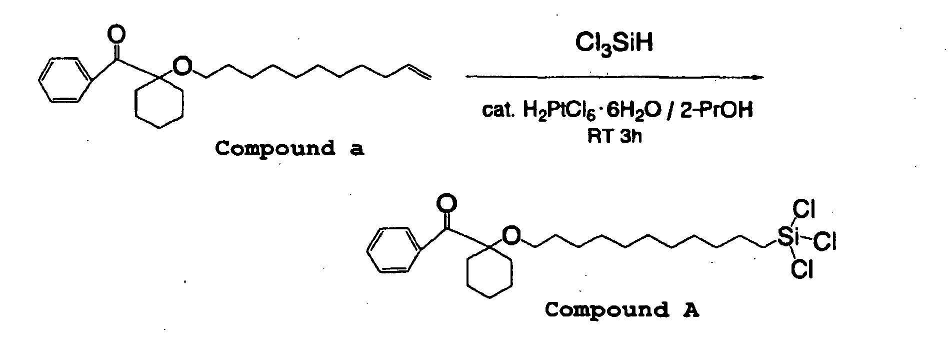

¹H-NMR (300 MHz, CDCl₃), δ = 1.2 to 1.8 (m, 30H), 3.2 (t, J = 6.3 Hz, 2H), 7.3 to 7.7 (m, 3H), 8.3 (d, 2H)

### (Bonding of a photocleavage compound)

A glass board (manufactured by Nippon Sheet Glass) as a substrate was immersed in a Piranha solution (a 1/1 by volume solution of sulfuric acid/30% hydrogen peroxide) for one night followed by washing with pure water. The substrate was placed in a separable flask substituted with nitrogen and immersed in a 12.5% by mass solution of the compound A in dehydrated toluene for 1 hour. After it was taken out, it was washed with toluene, acetone and pure water successively. As such, a substrate where a photocleavage compound was introduced onto the surface thereof was prepared.

### (Inactivation of polymerization initiating ability)

A pattern mask (NC-1 manufactured by Toppan Printing) was closely adhered by a clip to one side of the substrate into which the photocleavage compound was introduced and subjected to a pattern exposure to light using an exposing machine (UVX-02516S1LP01 manufactured by Ushio Denki) for 1 minute. As a result, a substrate in which a polymerization initiating region and a region where polymerization initiating ability was inactivated region was formed.

### - Formation of graft polymer -

A 5% by mass aqueous solution (5 ml) of a monomer comprising acrylic acid/glycidyl methacrylate (molar ratio: 80/20) was dropped onto the surface of the substrate where a polymerization initiating region and a region where polymerization initiating ability was inactivated region were formed and a quartz plate was covered thereon whereupon the aqueous monomer solution was uniformly sandwiched between the intermediate layer and the quartz plate. Above the quartz plate, an exposing machine (UVX-02516S1LP01 manufactured by Ushio Denki) was applied so that the whole surface was exposed for 5 minutes. As such, a substrate where a graft polymer comprising a copolymer of acrylic acid and glycidyl methacrylate was bonded onto the surface of the substrate in a pattern form was prepared.
The substrate where such a graft polymer pattern was formed is called a substrate B.

### [(2) Process for formation of a layer where electro-conductive particles are adsorbed and (3) process for formation of cross-linking structure]

The resulting substrate B was subjected to the same process for formation of a layer where electro-conductive particles are adsorbed (2) and process for formation of cross-linking structure (3) as in Example 1 to prepare an electro-conductive pattern material B of Example 2.

### [Comparative Examples 1 and 2]

The same operations as in Examples 1 and 2 were carried out except that, in the formation of a graft polymer in the process for the production of a graft polymer of Examples 1 and 2, a graft copolymer comprising acrylic acid only was produced instead of producing a graft polymer comprising acrylic acid and glycidyl methacrylate (in a 80/20 molar ratio) and further that no process for the formation of a cross-liking structure was conducted whereupon the electro-conductive materials C and D of Comparative Examples 1 and 2, respectively, were prepared.

### < Evaluations >

### (Confirmation of electro-conductive pattern)

When layers where electro-conductive particles were adsorbed (electro-conductive patterns) of the electro-conductive pattern materials A to D prepared in Examples and Comparative Examples were confirmed under a transmission electron microscope (JEOL JEM-200CX) with a 100,000 magnifying power, all of them were confirmed to form fine wirings with 8 µm line space and 8 µm space width.

### (Evaluation of surface electric conductivity)

Surface electric conductivity of the electro-conductive particle-adsorbing layers (electro-conductive patterns) of the electro-conductive pattern materials A to D prepared in Examples and Comparative Examples was measured by a four-needle method using a Loresta-FP (manufactured by Mitsubishi Chemical). The measured result is shown in the following Table 1.

### (Evaluation of durability)

Each of the electro-conductive materials A to D prepared in Examples and Comparative Examples was dipped into a saturated saline solution for 10 minutes and the surface electro-conductivities before and after the dipping were compared whereupon durability of retention of the electro-conductive particles was evaluated. Here, a method for the measurement of the surface electrical conductivity was the same as the measuring method for the surface electrical conductivity in the evaluation of electrical conductivity. Incidentally, the above-mentioned result of evaluation of the surface electric conductivity was adopted as the surface electric conductivity before dipping. Result of the measurement is shown in the following Table 1.

**[Table 1]**

| | Surface Electro-Conductivity before Immersion (Ω/□) | Surface Electro-Conductivity after Immersion (Ω/□) |
|---|---|---|
| Example 1 | 10 | 10 |
| Example 2 | 12 | 10 |
| Comparative Example 1 | 10 | 120 |
| Comparative Example 2 | 11 | 200 |

From the above-mentioned evaluation results, it was noted that, in the electro-conductive materials A and B where a cross-linking structure was formed in the electro-conductive particle-adsorbing layers, the surface electric conductivity before and after the dipping into a saturated saline solution was maintained in a high state and that durability was excellent.
On the contrary, in the electro-conductive pattern materials C and D of Comparative Examples 1 and 2 where a graft polymer solely comprising acrylic acid was produced to form electro-conductive particle-adsorbing layers and no cross-linking structure was formed on the electro-conductive particle-adsorbing layers, although a surface electric conductivity of nearly the same as in the Examples was noted before immersing into a saturated saline solution, there was a significant reduction in the surface electr0-conductivity after dipping into a saturated saline solution and it is likely that detachment of the electro-conductive particles was generated.

### [Example 3]

### [(1) Process for formation of graft polymer pattern]

A substrate A having a graft polymer pattern was prepared by the same manner as in the above-mentioned Example 1.

### [(2') Process for formation of a layer containing an electroless plating catalyst]

The substrate A was immersing in a 1% by mass aqueous solution of silver nitrate (manufactured by Wako Pure Chemicals) for 1 hour and then washed with distilled water. After that, it was immersed in a 1% by mass aqueous solution of sodium borohydride for 1 hour so that fine particles of silver nitrate were formed in the graft layer to form a layer containing an electroless plating catalyst.

### [(3) Process for formation of a cross-linking structure]

A substrate in which an electroless plating catalyst, etc. were contained therein was heated at 140°C for 5 minutes using a hot plate (type T2B, Banstead) so that carboxyl group and glycidyl group of the graft polymer were cross-linked whereupon a cross-linking structure was formed in a layer containing an electroless plating catalyst.

### [(4) Process for formation of electroless plating]

The substrate A where the cross-linking structure formation was finished was dipped into an electroless plating bath of the following composition for 20 minutes so that metal (copper) was separated whereupon an electro-conductive pattern material E of Example 3 was prepared.

### < Electroless plating bath composition >

- OPC Copper HT1 (manufactured by Okuno Seiyaku) 6 mL
- OPC Copper H T2 (manufactured by Okuno Seiyaku) 1.2 mL
- OPC Copper H T3 (manufactured by Okuno Seiyaku) 10 mL
- Water 83 mL

### [Example 4]

### [(1) Process for formation of graft polymer pattern]

A substrate B having a graft polymer pattern was prepared by the same manner as in the above Example 2.

### [(2) Process for formation of a layer containing an electroless plating catalyst, (3) process for formation of cross-linking structure and (4) process for electroless plating]

The resulting substrate B was subjected to the same (2) process for formation of a layer containing an electroless plating catalyst, (3) process for formation of cross-linking structure and (4) process for electroless plating as in Example 3 to give an electro-conductive pattern material F of Example 4.

### [Example 5]

The electro-conductive pattern material E prepared in Example 3 was further subjected to an electric plating for 15 minutes to prepare an electro-conductive pattern material G.

### < Composition of electro-plating bath >

- Copper sulfate 38 g
- Sulfuric acid 95 g
- Hydrochloric acid 1 mL
- Copper-Gleam PCM (manufactured by Meltec) 3 mL
- Water 500 mL

### [Example 6]

The electro-conductive material F prepared in Example 4 was subjected to an electric plating the same as in Example 3 for 15 minutes to prepare an electro-conductive material H.

### [Comparative Examples 3 and 4]

The same operations as in Examples 3 and 5 were carried out except that, in the formation of a graft polymer in the process for the production of a graft polymer of Examples 3 and 4, a graft copolymer comprising acrylic acid only was produced instead of producing a graft polymer comprising acrylic acid and glycidyl methacrylate (in a 80/20 molar ratio) and further that no process for the formation of a cross-liking structure was conducted whereupon the electro-conductive materials I and J of Comparative Examples 3 and 4, respectively, were prepared.

### [Comparative Example 5 and 6]

The electro-conductive materials I and J prepared in Comparative Examples 3 and 4 were further subjected to an electric plating by the same manner as in Example 5 for 15 minutes to prepare electro-conductive pattern materials K and L.

### < Evaluations >

### 1. Confirmation of electro-conductive pattern

When metal part (electro-conductive patterns) of the electro-conductive pattern materials E to L prepared in Examples and Comparative Examples were confirmed under a transmission electron microscope (JEOL JEM-200CX) with a 100,000 magnifying power, all of them were confirmed to form fine wirings with 15 µm line space and 15 µm space width.

### 2. Evaluation of surface electric conductivity)

Surface electric conductivity of the metal part (electro-conductive patterns) of the electro-conductive pattern materials E to L prepared in Examples and Comparative Examples was measured by a four-needle method using a Loresta-FP (manufactured by Mitsubishi Chemical). The measured result is shown in the following Table 2.

### 3. Evaluation of adhesiveness property

An aluminum plate (thickness: 0.1 mm) was adhered on the surface of each of the resulting electro-conductive pattern materials E to L using an epoxy adhesive (Araldite manufactured by Ciba-Geigy), dried at 140°C for 4 hours and subjected to a 90° release test according to JIS C 6481. The result is shown in the following Table 2.

### 4. Anti-moisture test

The resulting electro-conductive pattern materials E to L were allowed to stand for 7 days under the condition of 100°C an 85% RH and evaluated by conducted a release test using a Mylar tape. Criteria for the evaluation are as follows. The result is shown in the following Table 2.

### - Criteria for evaluation -

O: there was no fear for detachment of the metal part
x: there was a fear for detachment of the metal part

**[Table 2]**

| | Electro-Conductive Materials | Electric Conductivity (Ω/□) | Adhesiveness Property (kN/m) | Resistance to Moisture |
|---|---|---|---|---|
| Example 3 | Electro-Conductive Material E | 11 | 1.5 | O |
| Example 4 | Electro-Conductive Material F | 12 | 1.8 | O |
| Example 5 | Electro-Conductive Material G | 1.0 | 1.3 | O |
| Example 6 | Electro-Conductive Material H | 1.8 | 1.2 | O |
| Comp. Ex. 3 | Electro-Conductive Material I | 1.5 | 0.6 | x |
| Comp. Ex. 4 | Electro-Conductive Material J | 12 | 0.8 | x |
| Comp. Ex. 5 | Electro-Conductive Material K | 2.0 | 0.3 | x |
| Comp. Ex. 6 | Electro-Conductive Material L | 1.8 | 0.8 | x |

As shown in Table 2, the electro-conductive materials E to H of Examples 3 to 6 where a cross-linking structure was formed in an electroless plating catalyst-containing layer of a pattern form are electro-conductive membranes having a high electric conductivity and an excellent adhesiveness property and, even when being allowed to stand under high temperature and humidity for a long period, no metal part was detached but showed an excellent retention of holding the same. Accordingly, it is presumed that the metal separated by means of electroless plating is strongly held by the cross-linking structure of the graft polymer.
On the contrary, in the electro-conductive pattern materials I to L of Comparative Examples 3 to 6 where a graft polymer pattern solely comprising acrylic acid was produced to form an electroless plating catalyst-containing layer was formed and no cross-linking structure was formed in the electroless plating catalyst-containing layer, it was found that both electric conductivity and adhesiveness property were inferior to the electro-conductive membranes of the Examples and that, particularly, the duration of retention of the metal part was significantly reduced. Accordingly, it was presumed that the metal separated by an electroless plating was detached from the graft polymer under high humidity.

## Claims

1. A method for manufacturing an electro-conductive pattern material comprising:
bonding a graft polymer directly on a substrate in pattern form by contacting a polymerizable compound having a functional group which can interact with electro-conductive particles and a polymerizable compound having a cross-linking property at the substrate surface and supplying energy in a pattern form, wherein each of the polymerizable compounds is independently a monomer, macromonomer or a polymer having a polymerizable group;
forming an electro-conductive particle-adsorbing layer by adsorbing electro-conductive particles to the functional group which can interact with the electro-conductive particles of the graft polymer; and
forming a cross-linking structure in the electro-conductive particle-adsorbing layer by applying energy thereto.

2. A method according to Claim 1, wherein the graft polymer is formed from a monomer component including a functional group which can interact with the electro-conductive particles and a monomer component including a cross-linking functional group such that the graft polymer contains units derived from these polymerizable monomers in a molar ratio of from 30:70 to 99:1.

3. A method according to Claim 2, wherein the monomer including a functional group which can interact with the electro-conductive particles comprises a polymerizable monomer having a positive charge selected from ammonium and phosphonium and/or a polymerizable monomer having an acidic group which has a negative charge or is able to be dissociated into a negative charge selected from a sulfonic acid group, a carboxyl group, a phosphoric acid group and a phosphonic acid group.

4. A method according to Claim 2, wherein the polymerizable monomer including a cross-linking functional group is a monomer having one or more functional groups selected from a hydroxyl group, a methylol group, a glycidyl group, an isocyanate group and an amino group.

5. A method according to Claim 1, wherein the step for directly bonding the graft polymer in a pattern form includes pattern exposing by actinic radiation.

6. A method according to Claim 1, wherein the substrate has a layer containing a polymerizable compound and a polymerization initiator capable of initiating polymerization when energy is applied thereto.

7. A method for manufacturing an electro-conductive pattern material comprising:
bonding a graft polymer directly on a substrate in pattern form by contacting a polymerizable compound having a functional group which can interact with an electroless plating catalyst or a precursor thereof and a polymerizable compound having a cross-linking property at the substrate surface and supplying energy in a pattern form, wherein each of the polymerizable compounds is independently a monomer, macromonomer or a polymer having a polymerizable group;
forming an electroless plating catalyst-containing layer by adding the electroless plating catalyst or a precursor thereof to the graft polymer;
applying energy to the electroless plating catalyst-containing layer to form a cross-linking structure in the electroless plating catalyst-containing layer; and
conducting an electroless plating.

8. A method according to Claim 7, wherein the method further comprises the step of conducting electric plating after the completion of the electroless plating step.

9. A method according to Claim 7, wherein the graft polymer is formed from a monomer having a functional group which can interact with the electroless plating catalyst or precursor thereof and a monomer having a cross-linking functional group such that the graft polymer contains units derived from these polymerizable monomers in a molar ratio of from 30:70 to 99:1.

10. A method according to Claim 9, wherein the monomer having a functional group which can interact with the electroless plating catalyst or precursor thereof comprises one or more of a polymerizable monomer having a positive charge selected from ammonium and phosphonium and/or a polymerizable monomer having an acidic group which has a negative charge or is able to be dissociated into a negative charge selected from a sulfonic acid group, a carboxyl group, a phosphoric acid group and a phosphonic acid group.

11. A method according to Claim 9, wherein the monomer having a cross-linking functional group is a monomer having one or more functional group(s) selected from a hydroxyl group, a methylol group, a glycidyl group, an isocyanate group and an amino group.

12. A method according to Claim 7, wherein the step for directly bonding the graft polymer in a pattern form includes a pattern exposure step by actinic radiation.

13. A method according to Claim 7, wherein the substrate has a layer containing a polymerizable compound and a polymerization initiator capable of initiating polymerization when energy is applied thereto.

## Patentansprüche

1. Verfahren zur Herstellung eines elektroleitfähigen Strukturmaterials, welches die folgenden Schritte umfasst:
musterförmiges Verbinden eines Pfropfpolymers direkt auf einen Träger durch Kontaktieren einer polymerisierbaren Verbindung, die eine funktionelle Gruppe aufweist, die mit elektroleitfähigen Partikeln und einer polymerisierbaren Verbindung mit Vernetzungseigenschaften auf der Trägeroberfläche wechselwirken kann, und durch musterförmiges Bereitstellen von Energie, wobei jede der polymerisierbaren Verbindungen unabhängig voneinander ein Monomer, ein Makromonomer oder ein Polymer mit einer polymerisierbaren Gruppe ist;
Ausbilden einer elektroleitfähigen Partikeladsorptionsschicht durch Adsorption der elektroleitfähigen Partikel an den funktionellen Gruppen, die mit den elektroleitfähigen Partikeln des Pfropfpolymers wechselwirken können; und
Ausbilden einer Vernetzungsstruktur in der elektroleitfähigen Partikeladsorptionsschicht durch Energieanwendung.

2. Verfahren gemäss Anspruch 1, wobei das Pfropfpolymer durch eine Monomerkomponente, die eine funktionelle Gruppe einschliesst, die mit den elektroleitfähigen Partikeln wechselwirken kann, und durch eine Monomerkomponente, die eine vernetzungsfähige funktionelle Gruppe einschliesst, erhalten wird, so dass das Pfropfpolymer Einheiten enthält, die von diesen polymerisierbaren Monomeren in einem molaren Verhältnis von 30:70 bis 99:1 abgeleitet sind.

3. Verfahren gemäss Anspruch 2, wobei das Monomer, das funktionelle Gruppen einschliesst, die mit den elektroleitfähigen Partikeln wechselwirken können, ein polymerisierbares Monomer mit einer positiven Ladung, ausgewählt aus Ammonium und Phosphonium, und/oder einem polymerisierbaren Monomer mit einer Säuregruppe, die eine negative Ladung aufweist oder in eine negative Ladung dissoziierbar ist, und die ausgewählt ist aus einer Sulfonsäuregruppe, einer Carboxylgruppe, einer Phosphorsäuregruppe und einer Phosphonsäuregruppe, umfasst.

4. Verfahren gemäss Anspruch 2, wobei das polymerisierbare Monomer, das eine vernetzungsfähige funktionelle Gruppe einschliesst, ein Monomer ist, das eine oder mehrere funktionelle Gruppen, ausgewählt aus einer Hydroxylgruppe, einer Methyloylgruppe, einer Glycidylgruppe, einer Isocyanatgruppe und einer Aminogruppe, aufweist.

5. Verfahren gemäss Anspruch 1, wobei der Schritt des direkten musterförmigen Verbindens des Pfropfpolymers eine musterförmige Belichtung durch Aktinstrahlung einschliesst.

6. Verfahren gemäss Anspruch 1, wobei der Träger eine Schicht aufweist, die eine polymerisierbare Verbindung und einen Polymerisationsstarter enthält, der in der Lage ist, die Polymerisation zu starten, wenn Energie angewandt wird.

7. Verfahren zur Herstellung eines elektroleitfähigen Strukturmaterials, welches die folgenden Schritte umfasst:
musterförmiges Verbinden eines Pfropfpolymers direkt auf ein Substrat durch Kontaktieren einer polymerisierbaren Verbindung, die eine funktionelle Gruppe aufweist, die mit einem stromlosen Beschichtungskatalysator oder einem Vorläufer davon, und einer polymerisierbaren Verbindung mit Vernetzungseigenschaften auf der Trägeroberfläche wechselwirken kann, und durch musterförmiges Bereitstellen von Energie, wobei jede der polymerisierbaren Verbindungen unabhängig voneinander ein Monomer, ein Makromonomer oder ein Polymer mit einer polymerisierbaren Gruppe ist;
Ausbilden einer stromlosen beschichtungskatalysatorhaltigen Schicht durch Hinzufügen des stromlosen Beschichtungskatalysators oder eines Vorläufers davon zu dem Pfropfpolymer;
Anwenden von Energie auf die stromlose beschichtungskatalysatorhaltige Schicht, wodurch eine Vernetzungsstruktur in der stromlosen beschichtungskatalysatorhaltigen Schicht erhalten wird; und
Durchführen einer stromlosen Beschichtung.

8. Verfahren gemäss Anspruch 7, wobei das Verfahren weiterhin den Schritt des elektrischen Beschichtens nach Abschluss des stromlosen Beschichtungsschrittes umfasst.

9. Verfahren gemäss Anspruch 7, wobei das Pfropfpolymer durch ein Monomer mit einer funktionellen Gruppe, die mit dem stromlosen Beschichtungskatalysator oder einem Vorläufer davon wechselwirken kann, und durch ein Monomer mit vernetzungsfähigen funktionellen Gruppen erhalten wird, so dass das Pfropfpolymer in einem molaren Verhältnis von 30:70 bis 99:1 Einheiten enthält, die von diesen polymerisierbaren Einheiten abgeleitet sind.

10. Verfahren gemäss Anspruch 9, wobei das Monomer, das eine funktionelle Gruppe aufweist, die mit dem stromlosen Beschichtungskatalysator oder einem Vorläufer davon wechselwirken kann, ein oder mehrere polymerisierbare Monomere, die eine positive Ladung, ausgewählt aus Ammonium und Phosphonium, aufweist, und/oder ein polymerisierbares Monomer mit einer Säuregruppe, die eine negative Ladung aufweist oder in eine negative Ladung dissoziierbar ist, und die ausgewählt ist aus einer Sulfonsäuregruppe, einer Carboxylgruppe, einer Phosphorsäuregruppe und einer Phosphonsäuregruppe, umfasst.

11. Verfahren gemäss Anspruch 9, wobei das Monomer, das eine vernetzungsfähige funktionelle Gruppe aufweist, ein Monomer ist, das eine oder mehrere funktionelle Gruppen, ausgewählt aus einer Hydroxylgruppe, einer Methylolgruppe, einer Glycidylgruppe, einer Isocyanatgruppe und einer Aminogruppe, aufweist.

12. Verfahren gemäss Anspruch 7, wobei der Schritt des direkten musterförmigen Verbindens des Pfropfpolymers eine musterförmige Belichtung mit Aktinstrahlung einschliesst.

13. Verfahren gemäss Anspruch 7, wobei der Träger eine Schicht aufweist, die eine polymerisierbare Verbindung und einen Polymerisationsstarter enthält, der in der Lage ist, die Polymerisation zu starten, wenn Energie angewandt wird.

## Revendications

1. Procédé pour fabriquer une matière à motif électroconducteur comprenant :
la liaison d'un polymère greffé directement sur un substrat en forme de motif en mettant en contact un composé polymérisable ayant un groupe fonctionnel qui peut interagir avec des particules électroconductrices et un composé polymérisable ayant une propriété de réticulation au niveau de la surface de substrat et en amenant de l'énergie sous une forme de motif, dans lequel chacun des composés polymérisables est indépendamment un monomère, un macromonomère ou un polymère ayant un groupe polymérisable ;
la formation d'une couche adsorbant les particules électroconductrices en adsorbant des particules électroconductrices sur le groupe fonctionnel qui peut interagir avec les particules électroconductrices du polymère greffé ; et
la formation d'une structure de réticulation dans la couche adsorbant des particules électroconductrices en appliquant de l'énergie à celle-ci.

2. Procédé selon la revendication 1, dans lequel le polymère greffé est formé à partir d'un composant monomère incluant un groupe fonctionnel qui peut interagir avec les particules électroconductrices et un composant monomère incluant un groupe fonctionnel de réticulation de sorte que le polymère greffé contient des unités dérivées de ces monomères polymérisables dans un rapport molaire de 30 : 70 à 99 : 1.

3. Procédé selon la revendication 2, dans lequel le monomère incluant un groupe fonctionnel qui peut interagir avec les particules électroconductrices comprend un monomère polymérisable ayant une charge positive sélectionnée parmi l'ammonium et le phosphonium et/ou un monomère polymérisable ayant un groupe acide qui a une charge négative ou qui est susceptible d'être dissocié en une charge négative sélectionnée parmi un groupe acide sulfonique, un groupe carboxyle, un groupe acide phosphorique et un groupe acide phosphonique.

4. Procédé selon la revendication 2, dans lequel le monomère polymérisable incluant un groupe fonctionnel de réticulation est un monomère ayant un ou plusieurs groupes fonctionnels sélectionnés parmi un groupe hydroxyle, un groupe méthylol, un groupe glycidyle, un groupe isocyanate et un groupe amino.

5. Procédé selon la revendication 1, dans lequel l'étape de liaison directe du polymère greffé en une forme de motif inclut l'exposition de motif par rayonnement actinique.

6. Procédé selon la revendication 1, dans lequel le substrat a une couche contenant un composé polymérisable et un initiateur de polymérisation susceptible d'amorcer une polymérisation quand de l'énergie est appliquée à celui-ci.

7. Procédé pour fabriquer une matière à motif électroconducteur comprenant :
la liaison d'un polymère greffé directement sur un substrat en forme de motif en mettant en contact avec un composé polymérisable ayant un groupe fonctionnel qui peut interagir avec un catalyseur de placage autocatalytique ou un précurseur de celui-ci et un composé polymérisable ayant une propriété de réticulation au niveau de la surface de substrat et en amenant de l'énergie sous forme de motif, dans lequel chacun des composés polymérisables est indépendamment un monomère, un macromonomère ou un polymère ayant un groupe polymérisables ;
la formation d'une couche contenant un catalyseur de placage autocatalytique en ajoutant le catalyseur de placage autocatalytique ou un précurseur de celui-ci au polymère greffé ;
l'application d'énergie à la couche contenant un catalyseur de placage autocatalytique pour former une structure de réticulation dans la couche contenant un catalyseur de placage autocatalytique ; et
la conduite d'un placage autocatalytique.

8. Procédé selon la revendication 7, dans lequel le procédé comprend en outre l'étape consistant à conduire un placage électrique après l'achèvement de l'étape de placage autocatalytique.

9. Procédé selon la revendication 7, dans lequel le polymère greffé est formé à partir d'un monomère ayant un groupe fonctionnel qui peut interagir avec le catalyseur de placage autocatalytique ou un précurseur de celui-ci et d'un monomère ayant un groupe fonctionnel de réticulation de sorte que le polymère greffé contient des unités dérivées de ces monomères polymérisables dans un rapport molaire de 30 : 70 à 99 : 1.

10. Procédé selon la revendication 9, dans lequel le monomère ayant un groupe fonctionnel qui peut interagir avec le catalyseur de placage autocatalytique ou un précurseur de celui-ci comprend un ou plusieurs d'un monomère polymérisables ayant une charge positive sélectionnée parmi l'ammonium et le phosphonium et/ou un monomère polymérisable ayant un groupe acidifère qui a une charge négative ou qui est susceptible d'être dissocié en une charge négative sélectionnée parmi un groupe acide sulfonique, un groupe carboxyle, un groupe acide phosphorique et un groupe acide phosphonique.

11. Procédé selon la revendication 9, dans lequel le monomère ayant un groupe fonctionnel de réticulation est un monomère ayant un ou plusieurs groupe(s) fonctionnel(s) sélectionné(s) parmi un groupe hydroxyle, un groupe méthylol, un groupe glycidyle, un groupe isocyanate et un groupe amino.

12. Procédé selon la revendication 7, dans lequel l'étape de liaison directe du polymère greffé sous une forme de motif inclut une étape d'exposition de motif par rayonnement actinique.

13. Procédé selon la revendication 7, dans lequel le substrat a une couche contenant un composé polymérisable et un initiateur de polymérisation susceptible d'amorcer une polymérisation quand de l'énergie est appliquée à celui-ci.
